# EUROPEAN PATENT APPLICATION

(11) **EP 4 844 892 A1**
(43) Date of publication of application: **25.11.2026**
(21) Application number: 24932663.8
(22) Date of filing: 26.12.2024
(51) Int. Cl.: H01M 10/6551, H01M 10/613, H01M 10/617, H01M 10/625, H01M 10/647, H01M 10/656, H01M 10/6568

(54) **COOLING HEAT EXCHANGER**

(30) Priority: 28.03.2024 JP 2024053050; 31.10.2024 JP 2024191998
(71) Applicant: Sumitomo Riko Company Limited, Komaki-shi, Aichi 485-8550 (JP)
(72) Inventor: WAKAZONO, Yukinori, Komaki-shi, Aichi 485-8550 (JP); KANEGAE, Ryousuke, Komaki-shi, Aichi 485-8550 (JP)
(74) Representative: SSM Sandmair
(86) International application number: PCT/JP2024/046217
(87) International publication number: WO 2025/203956

(57) **Abstract**

Provided is a cooling heat exchanger having a novel structure with which a double-sided cooling structure having a cooling surface on both sides is realized in a simple structure, and with which excellent cooling performance can be stably obtained. A cooling heat exchanger 10 has formed in the interior thereof a cooling channel 28 through which a cooling heat medium flows, and the cooling heat exchanger cools a cooling object 62 that is layered on a cooling surface 32 provided on the surface of the cooling heat exchanger. A hollow outer wall member 12 having the cooling channel 28 therein is provided. A pair of cooling wall parts 30, 30 each have the cooling surface 32 on a surface of the cooling wall parts, and the cooling wall parts are provided to mutually opposing sections of the outer wall member 12. In an internal region 28 of the outer wall member 12, arranged is a plate-like inner fin 34 bisecting the internal region 28 in the opposing direction of the pair of cooling wall parts 30, 30. A first projection 48a and a second projection 48b, each protruding to opposing surfaces, are formed integrally in the inner fin 34.

## Description

### Technical Field

The present disclosure relates to a cooling heat exchanger to be used for cooling a cooling target such as a battery and the like used in a motorized vehicle, for example.

### Background Art

A cooling heat exchanger used for cooling a battery or an inverter has conventionally been known. As disclosed in Japanese Patent No. JP-B-7000777, for example, the cooling heat exchanger has a configuration with a cooling flow path formed inside an outer wall member and used for causing a heat medium to flow therein. The cooling heat exchanger is configured to cool a cooling target such as a battery by superposing the cooling target on a cooling surface provided on a surface thereof to exchange heat between the cooling target and the heat medium.

The cooling heat exchanger of JP-B-7000777 has a double-sided cooling configuration where a pair of cooling walls forming the outer wall member are arranged face-to-face and cooling surfaces are defined on respective outer surfaces of the pair of cooling walls, thereby allowing cooling of the cooling targets superposed on the cooling surfaces provided on the respective surfaces.

### Prior Art Document(s)

### Patent Document(s)

Patent Document 1: JP 7000777 B

### Summary of the Invention

### Problem to be solved by the Invention

According to JP-B-7000777, for the purpose of improving the efficiency of cooling the cooling surface using the heat medium by providing a large area of contact with the heat medium, an inner fin is housed inside the outer wall member. For the purpose of performing efficient double-sided cooling, JP-B-7000777 has a configuration where an internal space of the outer wall member is separated by a middle plate in a direction in which the pair of cooling walls face each other, and the inner fins are arranged on both sides of the middle plate.

However, the configuration of JP-B-7000777 requires the middle plate and the two inner fins to cause a problem of increased parts count and complication of the configuration.

Furthermore, only the heat medium flowing through a position closer to the cooling target is brought to high temperature through heat exchange with the cooling target, causing a risk of cooling performance reduction resulting from the heat exchange with the heat medium flowing through the position closer to the cooling target. Moreover, as the heat medium flowing through a position farther from the cooling target cools the cooling target indirectly across the middle plate or the inner fin, it is more likely to reduce heat exchange efficiency than the heat medium flowing through the position closer to the cooling target. This causes a risk of cooling performance reduction for failing to use the heat capacity of the heat medium entirely.

A problem to be solved by the present disclosure is to provide a cooling heat exchanger having a novel structure capable of achieving excellent cooling performance stably while realizing a double-sided cooling configuration including cooling surfaces arranged on both surfaces in a simple structure.

### Means for Solving Problem

Hereinafter, preferred embodiments for grasping the present disclosure will be described. However, all the preferred embodiments described below are exemplary and can be appropriately combined with each other. Besides, a plurality of elements described in each preferred embodiment can be recognized and adopted as independently as possible, or can also be appropriately combined with any element described in other preferred embodiments. By so doing, in the present disclosure, various other preferred embodiments can be realized without being limited to those described below.

A first preferred embodiment provides a cooling heat exchanger including a cooling flow path for causing a cooling heat medium to flow therein, and a cooling surface provided on a surface of the cooling heat exchanger while being configured to be superposed on a cooling target for cooling the cooling target, the cooling heat exchanger comprising: a hollow outer wall member in which the cooling flow path is provided, the hollow outer wall member including a pair of cooling walls separately provided at portions of the hollow outer wall member facing each other and each including the cooling surface formed on a surface of the cooling wall; and an inner fin having a plate shape and arranged in an internal region of the hollow outer wall member, the inner fin separating the internal region into two in a direction in which the pair of cooling walls face each other while integrally including at least one first projection and at least one second projection jutting out from respective surfaces of the inner fin.

According to the cooling heat exchanger structured following the present preferred embodiment, by separating the cooling flow path using one inner fin into two in the direction in which the pair of cooling walls face each other, it becomes possible to realize the cooling flow path separated suitably for double-sided cooling in a simple configuration. Furthermore, as providing the inner fin in the internal region of the outer wall member increases an area of contact with the heat medium, the pair of cooling walls are further cooled through indirect heat exchange with the heat medium via the inner fin, for example, thereby encouraging improvement in performance of cooling the cooling target.

The inner fin integrally includes the first projection and the second projection jutting out from the respective surfaces of the inner fin. Thus, when the heat medium flows through both sides of the inner fin, directions of the flow are changed by the first projection and the second projection. This causes generation of a vortex flow or a turbulent flow, separation of the heat medium from the inner fin to be guided toward the cooling wall, and others, for example, thereby stirring the heat medium. The heat medium flowing through a position closer to the cooling wall and warmed through heat exchange with the cooling target and the heat medium flowing through a position farther from the cooling wall (a position closer to the inner fin) and kept at comparatively low temperature are stirred and these heat media differing in temperature are mixed with each other. This prevents reduction in efficiency of heat exchange with the cooling target to be caused by partial temperature increase of the heat medium to effectively use the heat capacity of the heat medium entirely for cooling of the cooling target, thereby encouraging improvement in cooling performance.

As the first projection and the second projection are provided in such a way as to jut out at the respective surfaces of the inner fin partitioning the cooling flow path, it is possible to obtain stirring action using the projections at respective flow paths on both sides of the inner fin with small parts count and a small number of manufacturing steps.

A second preferred embodiment provides the cooling heat exchanger according to the first preferred embodiment, wherein the cooling flow path includes a parallel flow path portion composed of a plurality of flow path parts separated in a flow path width direction by the inner fin while extending in parallel and next to each other, and the heat medium flows in a same direction in the plurality of flow path parts forming the parallel flow path portion.

According to the cooling heat exchanger structured following the present preferred embodiment, by using the inner fin to form the parallel flow path portion composed of the plurality of parallel flow path parts, it becomes possible for the inner fin to further function as a flow regulation fin for regulating the flow of the heat medium. It is further possible to adjust and set a flow path cross-sectional area of each flow path part easily using the inner fin. By adjusting the flow rate and flow velocity of the heat medium in each flow path part, it becomes possible to achieve intended cooling performance.

As the inner fin forms a wall for partitioning the flow path parts next to each other, an area of contact of the inner fin with the heat medium is increased further. Thus, indirect cooling of the cooling surface via the inner fin is achieved more efficiently.

The size of the parallel flow path portion composed of the plurality of flow path parts in the flow path width direction is adjustable using the number of the flow path parts. Thus, by providing the parallel flow path portion at a position corresponding to the cooling surface, for example, it becomes possible to set the size of the cooling surface in the flow path width direction with a higher degree of freedom while setting the flow path cross-sectional area of each flow path part appropriately.

As the plurality of parallel flow path parts forming the parallel flow path portion causes the heat medium to flow therein in the same flow direction, it is unlikely that cooling performance will be reduced through heat exchange between the flow path parts next to each other.

A third preferred embodiment provides the cooling heat exchanger according to the first or second preferred embodiment, wherein the hollow outer wall member has a structure in which a first member forming one of the pair of cooling walls and a second member forming an other of the pair of cooling walls are superposed on each other in the direction in which the pair of cooling walls face each other, and the inner fin is arranged between the first member and the second member facing each other.

According to the cooling heat exchanger structured following the present preferred embodiment, providing the inner fin between respective superposed surfaces of the first member and the second member allows the inner fin to be housed and arranged easily in the internal region of the outer wall member.

A fourth preferred embodiment provides the cooling heat exchanger according to any one of the first to third preferred embodiments, wherein the inner fin has a cross section folded back in a zigzag pattern or a wave pattern in the direction in which the pair of cooling walls face each other, and the first projection and the second projection are formed between fold apexes of the inner fin next to each other.

According to the cooling heat exchanger structured following the present preferred embodiment, it is possible to separate the internal region of the outer wall member using the inner fin having the simple shape. In particular, forming the inner fin into a cross section in a zigzag pattern or a wave pattern makes it possible to provide the plurality of parallel flow path parts partitioned by the inner fin.

As the inner fin has a cross section folded back in a zigzag pattern or a wave pattern, it is possible to ensure the stiffness against deformation of the inner fin easily. Thus, thickness reduction of the inner fin can be encouraged, for example. Moreover, forming the first projection and the second projection between the fold apexes of the inner fin allows the stiffness against deformation of the inner fin to be improved further.

A fifth preferred embodiment provides the cooling heat exchanger according to any one of the first to third preferred embodiments, wherein the inner fin includes a middle separator arranged apart from both the pair of cooling walls of the hollow outer wall member and separating a region between facing surfaces of the pair of cooling walls into two in the direction in which the pair of cooling walls face each other, the first projection and the second projection are formed at the middle separator, the inner fin includes a partition wall protruding from the middle separator to both sides toward the pair of cooling walls, and the internal region of the hollow outer wall member is separated by the partition wall into a plurality of flow path parts in a flow path width direction of the cooling flow path.

According to the cooling heat exchanger structured following the present preferred embodiment, the internal region of the outer wall member is separated by one inner fin not only in the direction in which the pair of cooling walls face each other but is separated into two or more in the flow path width direction of the cooling flow path, thereby forming the plurality of flow path parts. As a result, it is possible to set the number of the flow path parts, flow path cross-sectional areas thereof, and others easily with a high degree of freedom on the basis of a spacing between the partition walls or the number of the partition walls provided at one inner fin.

As the first projection and the second projection are provided at the middle separator, turbulent flow facilitating action using the projection is fulfilled in each flow path region, thereby achieving excellent cooling performance.

A sixth preferred embodiment provides the cooling heat exchanger according to any one of the first to fifth preferred embodiments, wherein each of the first projection and the second projection has a V-shape on the corresponding surface of the inner fin and becomes narrower toward an upstream side of the cooling flow path.

According to the cooling heat exchanger structured following the present preferred embodiment, in climbing over the V-shape first projection or second projection, the heat medium flows in a direction inclined toward the center of the V-shape in the flow path width direction so as to reduce a flow resistance. Thus, flows of the heat medium having climbed over the first projection or the second projection join each other to generate a vortex flow or a turbulent flow on a downstream side with respect to the first projection or the second projection. As a result, the heat medium is stirred more efficiently to reduce a temperature difference of the heat medium (achieve temperature uniformity), thereby encouraging improvement in cooling performance.

A seventh preferred embodiment provides the cooling heat exchanger according to any one of the first to sixth preferred embodiments, wherein the inner fin is arranged partially in a flow path length direction of the cooling flow path.

According to the cooling heat exchanger structured following the present preferred embodiment, weight reduction or cost reduction is encouraged, for example, by eliminating the inner fin from a part where double-sided cooling is unnecessary. As the inner fin including the first projection and the second projection is provided in a part where double-sided cooling is necessary, high cooling performance can be expected by stirring of the heat medium.

An eighth preferred embodiment provides the cooling heat exchanger according to any one of the first to seventh preferred embodiments, wherein the at least one first projection comprises a plurality of first projections, and the at least one second projection comprises a plurality of second projections, and regions where action of disturbing a flow of the heat medium works differently from each other by using at least one of the plurality of first projections and the plurality of second projections are defined in the cooling flow path.

According to the cooling heat exchanger structured following the present preferred embodiment, in the presence of parts in the cooling surface where cooling performance is requested to be fulfilled differently, for example, the action of disturbing the flow of the heat medium is set to work intensely in a part where higher cooling performance is requested. This facilitates a turbulent flow, so that partial improvement in cooling performance can be encouraged.

A ninth preferred embodiment provides the cooling heat exchanger according to the eighth preferred embodiment, wherein the regions where the action of disturbing the flow of the heat medium works differently from each other are defined at different positions in a flow direction of the heat medium in the cooling flow path.

According to the cooling heat exchanger structured following the present preferred embodiment, the turbulent flow facilitating action of disturbing the flow of the heat medium works differently in the flow direction of the heat medium. Thus, if a part where a large temperature difference is likely to occur between the heat medium closer to the cooling target and the heat medium farther from the cooling target and a part where a large temperature difference is unlikely to occur between these heat media are located at different positions in the flow direction of the cooling flow path, for example, a region where the turbulent flow facilitating action works intensely is defined in the part where a large temperature difference is likely to occur between the heat medium closer to the cooling target and the heat medium farther from the cooling target. By so doing, it becomes possible to reduce a temperature difference in the flow direction of the heat medium.

In a part where a large temperature difference is unlikely to occur in the cooling flow path between the heat medium at a position closer to the cooling target and the heat medium at a position farther from the cooling target, defining a region where turbulence in the flow of the heat medium is suppressed realizes smooth flow of the heat medium.

A tenth preferred embodiment provides the cooling heat exchanger according to the ninth preferred embodiment, wherein the regions where the action of disturbing the flow of the heat medium works differently from each other and defined at the different positions in the flow direction of the heat medium in the cooling flow path are set such that the action of disturbing the flow of the heat medium works more intensely in the region located on a more downstream side.

According to the cooling heat exchanger structured following the present preferred embodiment, on the downstream side where a large temperature difference is likely to occur between the heat medium flowing through a position closer to the cooling target and the heat medium flowing through a position farther from the cooling target, uniformity in temperature of the heat medium is encouraged by the stirring action resulting from disturbing the flow of the heat medium. Thus, high cooling performance can be fulfilled.

An eleventh preferred embodiment provides the cooling heat exchanger according to any one of the eighth to tenth preferred embodiments, wherein the cooling flow path includes a parallel flow path portion composed of a plurality of flow path parts separated by the inner fin while extending in parallel and next to each other, the heat medium flows in a same direction in the plurality of flow path parts forming the parallel flow path portion, and at least one pair of the flow path parts next to each other in the parallel flow path portion include the respective regions where the action of disturbing the flow of the heat medium works differently from each other.

According to the cooling heat exchanger structured following the present preferred embodiment, if the amount of heat to be generated differs at the cooling target in the flow path width direction, for example, a turbulence in the flow of the heat medium can be set intensely in an area where the amount of heat to be generated by the cooling target is large, and a turbulence in the flow of the heat medium can be set weakly in an area where the amount of heat to be generated by the cooling target is small. This makes it possible to encourage stabilization of cooling performance.

A twelfth preferred embodiment provides the cooling heat exchanger according to any one of the eighth to eleventh preferred embodiments, wherein the regions where the action of disturbing the flow of the heat medium works differently from each other are defined on a basis of at least one of a difference in distance between the plurality of first projections and a difference in distance between the plurality of second projections in a flow direction of the heat medium.

According to the cooling heat exchanger structured following the present preferred embodiment, it is possible to define a region where the action of disturbing the flow of the heat medium (turbulent flow facilitating action) works intensely by reducing a distance between the first projections and/or a distance between the second projections in the flow direction of the heat medium, and is possible to define a region where the turbulent flow facilitating action works weakly by increasing a distance between the first projections and/or a distance between the second projections in the flow direction of the heat medium, for example. On the basis of such a difference in spacing between provisions of the first projections and/or a difference in spacing between provisions of the second projections, it is possible to easily define the regions where the action of disturbing the flow of the heat medium works differently from each other.

A thirteenth preferred embodiment provides the cooling heat exchanger according to any one of the eighth to twelfth preferred embodiments, wherein the regions where the action of disturbing the flow of the heat medium works differently from each other are defined on a basis of at least one of a difference in height between the plurality of first projections and a difference in height between the plurality of second projections.

According to the cooling heat exchanger structured following the present preferred embodiment, it is possible to define a region where the action of disturbing the flow of the heat medium (turbulent flow facilitating action) works intensely by increasing the height of the first projection and/or the height of the second projection partially, and is possible to define a region where the turbulent flow facilitating action works weakly by reducing the height of the first projection and/or the height of the second projection partially, for example. On the basis of such a difference in height between the plurality of first projections and/or a difference in height between the plurality of second projections, it is possible to easily define the regions where the action of disturbing the flow of the heat medium works differently from each other.

A fourteenth preferred embodiment provides the cooling heat exchanger according to any one of the first to thirteenth preferred embodiments, wherein the cooling target comprises a battery.

According to the cooling heat exchanger structured following the present preferred embodiment, in cooling the battery where local temperature increase is likely to occur in an output terminal part, for example, adjusting the arrangement of the first projections and/or the arrangement of the second projections allows a high-temperature part of the battery to be cooled efficiently. Furthermore, in cooling a battery unit composed of a plurality of batteries, for example, adjusting the arrangement of the first projections and/or the arrangement of the second projections also allows all of these batteries to be cooled effectively. Thus, it is possible to prevent performance reduction of the battery unit as a whole due to deterioration of a particular battery.

A fifteenth preferred embodiment provides the cooling heat exchanger according to any one of the first to fourteenth preferred embodiments, wherein the inner fin includes an elastically-deformable part to be deformed elastically to allow approach by deformation between the pair of cooling walls.

According to the cooling heat exchanger structured following the present preferred embodiment, if a battery as the cooling target bulges and is deformed by heating resulting from charging or discharging thereof, for example, deformations of the pair of cooling walls toward sides of approaching each other in conformity with the bulge and deformation of the battery are allowed by the elastic deformation of the elastically-deformable part of the inner fin arranged between facing surfaces of the pair of cooling walls. Thus, even in a configuration with the inner fin arranged between the facing surfaces of the pair of cooling walls, the deformations of the cooling walls in conformity with a surface shape of the cooling target prevent trouble such as separation between superposed surfaces of the cooling target and the cooling surface to be caused by the deformation of the cooling target, thereby fulfilling stable cooling performance.

A sixteenth preferred embodiment provides the cooling heat exchanger according to any one of the first to fifteenth preferred embodiments, wherein each of the first projection and the second projection extends over an entire flow path width of the cooling flow path and is continuous with side walls of the cooling flow path at respective ends.

According to the cooling heat exchanger structured following the present preferred embodiment, it is possible to prevent the heat medium from bypassing the first or second projection and flowing between the side wall of the cooling flow path and the first or second projection, thereby encouraging efficient improvement in cooling performance. If the first or second projection is spaced apart from the side wall of the cooling flow path, the flow velocity of the heat medium flowing between the side wall of the cooling flow path and the first or second projection is increased easily, causing a risk of erosion of the side wall of the cooling flow path or the first or second projection. By contrast, in the cooling heat exchanger of the present preferred embodiment, each of the first and second projections extends over the entire flow path width of the cooling flow path and is continuous with the side wall of the cooling flow path. This can prevent the flow of the heat medium between the side wall of the cooling flow path and the first or second projection, so that erosion of the wall of the cooling flow path or the first or second projection can be prevented.

A seventeenth preferred embodiment provides the cooling heat exchanger according to any one of the first to sixteenth preferred embodiments, wherein a jutting height of at least one of the first projection and the second projection changes in a flow path width direction of the cooling flow path, the at least one of the first projection and the second projection includes a low jutting portion having a small jutting height and a high jutting portion having a large jutting height, one of the low jutting portion and the high jutting portion is located in a center part in the flow path width direction, and an other of the low jutting portion and the high jutting portion is located on each end in the flow path width direction.

According to the cooling heat exchanger structured following the present preferred embodiment, it is possible to generate a difference in stirring action, flow velocity, etc. between a flow of the heat medium flowing while climbing over the center part in the flow path width direction of the projection and a flow of the heat medium flowing while climbing over each end in the flow path width direction of the first projection and/or the second projection. This allows the first projection and/or the second projection to exert influence over cooling performance differently between the center part and each end in the flow path width direction, so that cooling performance can be regulated in the flow path width direction.

An eighteenth preferred embodiment provides the cooling heat exchanger according to the seventeenth preferred embodiment, wherein the at least one first projection comprises a plurality of first projections arranged along a flow path length direction of the cooling flow path, and the at least one second projection comprises a plurality of second projections arranged along the flow path length direction of the cooling flow path, and at least one of the plurality of first projections and the plurality of second projections is composed of a center-low projection and a center-high projection arranged alternately in the flow path length direction of the cooling flow path, the center-low projection including the low jutting portion defined in the center part and the high jutting portion defined at each end in the flow path width direction of the cooling flow path, while the center-high projection including the high jutting portion defined in the center part and the low jutting portion defined at each end in the flow path width direction of the cooling flow path.

According to the cooling heat exchanger structured following the present preferred embodiment, as a result of the alternate arrangement in the flow path length direction with the center-low projection including the low jutting portion defined in the center part in the flow path width direction and the center-high projection including the low jutting portion defined at each end in the flow path width direction, the heat medium linking the low jutting portions where a flow resistance is suppressed easily flows in a meandering pattern in the flow path width direction, for example. This allows the action of stirring the heat medium to work in the flow path width direction. Moreover, by causing the heat medium having passed through the low jutting portion of one projection to flow toward the high jutting portion of a next projection, for example, the heat medium having passed through the low jutting portion smoothly at a comparatively low flow resistance collides with the high jutting portion. This further encourages expectation for efficient stirring of the heat medium.

A nineteenth preferred embodiment provides the cooling heat exchanger according to any one of the first to eighteenth preferred embodiments, wherein at least one of the first projection and the second projection has a cross-sectional shape tapered toward a jutting tip in a cross section in a flow path length direction of the cooling flow path, and includes an arc-like projection apex, an upstream inclined part, and a downstream inclined part provided smoothly and continuously with each other without a corner, the upstream inclined part extending from the arc-like projection apex toward a projection base on a side of a bottom surface of the cooling flow path in an inclined pattern toward an upstream side of the cooling flow path, the downstream inclined part extending from the arc-like projection apex toward the projection base in an inclined pattern toward a downstream side.

According to the cooling heat exchanger structured following the present preferred embodiment, the projection has a smooth and continuous surface in the cross section in the flow path length direction. This smoothly generates a flow of the heat medium in climbing over the projection.

A twentieth preferred embodiment provides the cooling heat exchanger according to the nineteenth preferred embodiment, wherein in the cross section in the flow path length direction of the cooling flow path, the arc-like projection apex has a radius of curvature within a range from 0.05 to 1.5 times a length dimension of the projection base, and in the cross section in the flow path length direction of the cooling flow path, an inclination angle of the upstream inclined part with respect to the bottom surface of the cooling flow path is within a range from 20° to 70°.

According to the cooling heat exchanger structured following the present preferred embodiment, by setting the radius of curvature of the projection apex equal to or greater than 0.05 times the length dimension of the projection base, the projection apex is formed into a cross section having a smooth arc pattern without a substantial corner. Furthermore, by setting the radius of curvature of the projection apex equal to or less than 1.5 times the length dimension of the projection base, it becomes possible to prevent the length dimension of the projection from increasing excessively in the flow path length direction and also possible to set the inclination angle with respect to the bottom surface sufficiently large for each of the upstream inclined part and the downstream inclined part smoothly continuous with the projection apex.

By setting the inclination angle of the upstream inclined part with respect to the bottom surface of the cooling flow path equal to or greater than 20°, a flow of the heat medium from the upstream side toward the projection is disturbed effectively by the upstream inclined part, thereby encouraging improvement in cooling performance by the stirring action. Furthermore, by setting the inclination angle of the upstream inclined part with respect to the bottom surface of the cooling flow path equal to or less than 70°, it becomes possible to prevent the flow of the heat medium from being restricted excessively by the projection.

A twenty-first preferred embodiment provides the cooling heat exchanger according to the nineteenth preferred embodiment, wherein in the cross section in the flow path length direction of the cooling flow path, an inclination angle of the upstream inclined part with respect to the bottom surface of the cooling flow path is equal to or less than 25°.

According to the cooling heat exchanger structured following the present preferred embodiment, setting the inclination angle of the upstream inclined part with respect to the bottom surface of the cooling flow path equal to or less than 25° allows pressure loss to be set sufficiently small. Thus, it becomes possible to cause the heat medium to flow using an inexpensive pump having lower performance, for example.

A twenty-second preferred embodiment provides the cooling heat exchanger according to any one of the first to twenty-first preferred embodiments, wherein the at least one first projection comprises a plurality of first projections arranged along a flow path length direction in the cooling flow path and the at least one second projection comprises a plurality of second projections arranged along the flow path length direction in the cooling flow path, at least one of the plurality of first projections and the plurality of second projections having jutting heights that increase toward a downstream side.

According to the cooling heat exchanger structured following the present preferred embodiment, by increasing the jutting heights of the first projections and/or the second projections arranged along the flow path length direction toward the downstream side, it becomes possible to fulfill the action of disturbing the flow of the heat medium using the projection more intensely on the downstream side. Thus, the effect of improving cooling performance using the projection is achieved more advantageously on the downstream side where the heat medium flowing through a position close to the cooling target is likely to be brought to high temperature through heat exchange.

A twenty-third preferred embodiment provides the cooling heat exchanger according to any one of the first to twenty-second preferred embodiments, wherein the at least one first projection comprises a plurality of first projections arranged along a flow path length direction in the cooling flow path and the at least one second projection comprises a plurality of second projections arranged along the flow path length direction in the cooling flow path, at least one of the plurality of first projections and the plurality of second projections having spacings that decrease toward a downstream side in the flow path length direction of the cooling flow path.

According to the cooling heat exchanger structured following the present preferred embodiment, by the first projections and/or the second projections arranged along the flow path length direction having spacings that decrease toward the downstream side, it becomes possible to fulfill the action of disturbing the flow of the heat medium using the projection more intensely on the downstream side. Thus, the effect of improving cooling performance using the projection is achieved more advantageously on the downstream side likely to be brought to high temperature through heat exchange with the cooling target.

A twenty-fourth preferred embodiment provides the cooling heat exchanger according to any one of the first to twenty-third preferred embodiments, wherein the at least one first projection comprises a plurality of first projections arranged along a flow path length direction in the cooling flow path and the at least one second projection comprises a plurality of second projections arranged along the flow path length direction in the cooling flow path, at least one of the plurality of first projections and the plurality of second projections having jutting heights that increase toward a downstream side while having spacings that decrease toward the downstream side in the flow path length direction of the cooling flow path.

According to the cooling heat exchanger structured following the present preferred embodiment, by increasing the height of the projection and decreasing the spacing (pitch) between the projections toward the downstream side, the stirring action of disturbing the flow of the heat medium using the projection works more intensely toward the downstream side. Thus, according to the present preferred embodiment, cooling performance reduction on the downstream side is suppressed more effectively.

### Effect of the Invention

According to the present disclosure, in the cooling heat exchanger, it is possible to achieve excellent cooling performance stably while realizing a double-sided cooling configuration including the cooling surfaces arranged on the both surfaces in a simple structure.

### BRIEF DESCRIPTION OF THE DRAWINGS

The foregoing and/or other objects, features and advantages of the disclosure will become more apparent from the following description of practical embodiments with reference to the accompanying drawings in which like reference numerals designate like elements and wherein:
FIG. 1 is an exploded perspective view depicting a cooling heat exchanger according to a first practical embodiment of the present disclosure;
FIG. 2 is a cross-sectional view of the cooling heat exchanger depicted in FIG. 1 and is a view corresponding to a cross section along 2-2 in FIG. 3;
FIG. 3 is a cross-sectional view along 3-3 in FIG. 2;
FIG. 4 is a plan view of an inner fin forming the cooling heat exchanger depicted in FIG. 1;
FIG. 5 is a view depicting a cross section along 5-5 in FIG. 4 in an enlarged manner;
FIG. 6 is a perspective view of the cooling heat exchanger depicted in FIG. 1 with battery packs mounted;
FIG. 7 is an exploded perspective view depicting a cooling heat exchanger according to a second practical embodiment of the present disclosure;
FIG. 8 is an exploded perspective view depicting a cooling heat exchanger according to a third practical embodiment of the present disclosure;
FIG. 9 is a plan view of an inner fin forming a cooling heat exchanger according to a fourth practical embodiment of the present disclosure;
FIG. 10 is a plan view of an inner fin forming a cooling heat exchanger according to a fifth practical embodiment of the present disclosure;
FIG. 11 is a cross-sectional view of the inner fin depicted in FIG. 10 and is a view depicting a part of a cross section along 11-11 in FIG. 12 in an enlarged manner;
FIG. 12 is an enlarged cross-sectional view corresponding to a cross section along 12-12 in FIG. 10;
FIG. 13 is an enlarged cross-sectional view corresponding to a cross section along 13-13 in FIG. 10;
FIG. 14 is a plan view of an inner fin forming a cooling heat exchanger according to a sixth practical embodiment of the present disclosure;
FIG. 15 is an enlarged cross-sectional view corresponding to a cross section along 15-15 in FIG. 14;
FIG. 16 is an enlarged cross-sectional view corresponding to a cross section along 16-16 in FIG. 14;
FIG. 17 is a cross-sectional view depicting a part of an inner fin forming a cooling heat exchanger according to a seventh practical embodiment of the present disclosure; and
FIG. 18 is a cross-sectional view depicting a part of an inner fin forming a cooling heat exchanger according to another practical embodiment of the present disclosure.

### DETAILED DESCRIPTION

Hereinafter, practical embodiments of the present disclosure will be described in reference to the drawings.

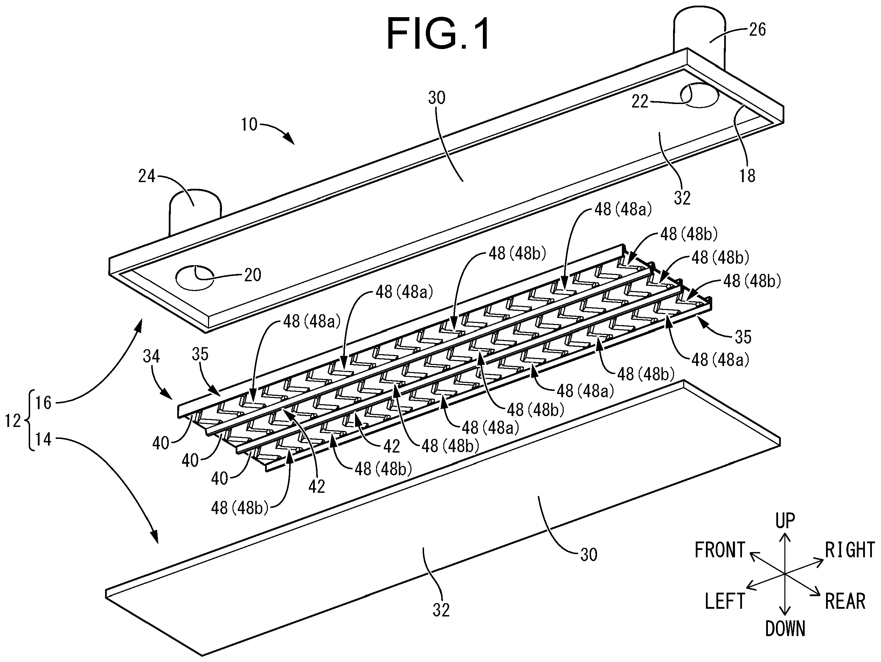

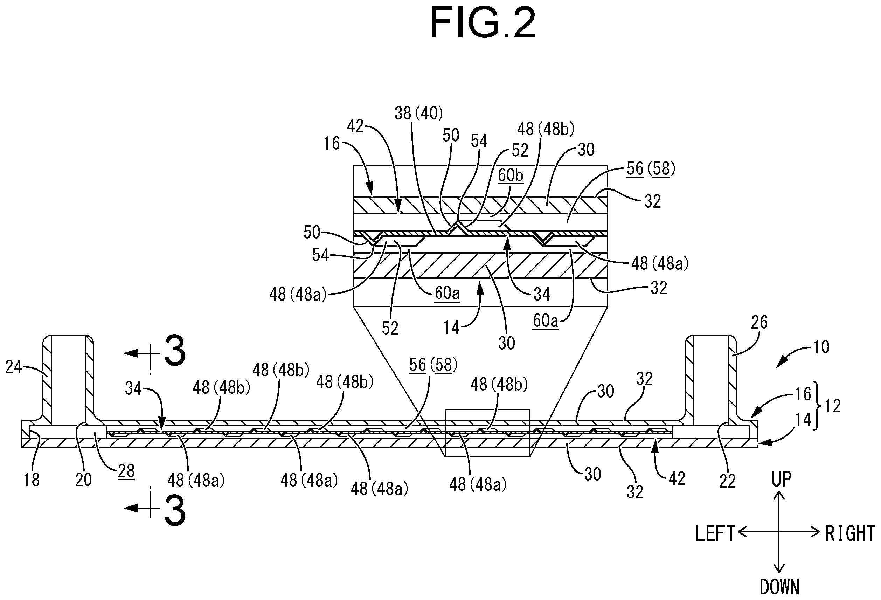

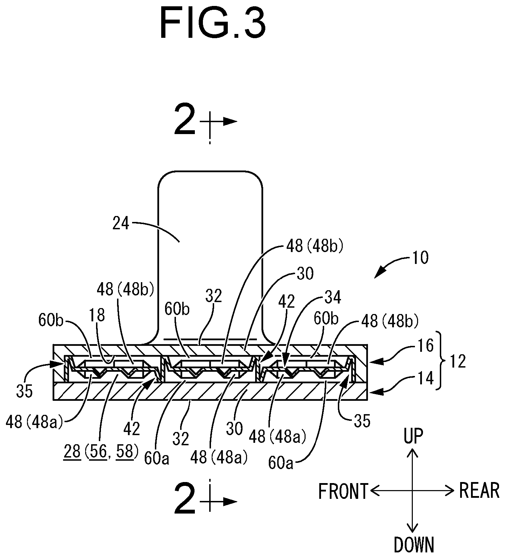

FIGS. 1 to 3 depict a cooling heat exchanger 10 according to a first practical embodiment of the present disclosure. As depicted in FIGS. 2 and 3, the cooling heat exchanger 10 includes a hollow outer wall member 12, and the outer wall member 12 is composed of a first member 14 and a second member 16. In the following description, in principle, an up-down direction refers to an up-down direction in FIG. 2, a left-right direction refers to a left-right direction in FIG. 2, and a front-rear direction refers to a left-right direction in FIG. 3. All the up-down direction, the left-right direction, and the front-rear direction are directions defined for convenience of description. Thus, a vertical up-down direction in a used state of the cooling heat exchanger 10 may be the above up-down direction, left-right direction, or front-rear direction in the present practical embodiment, or may be a direction not conforming to any one of the up-down direction, the left-right direction, and the front-rear direction, for example.

The first member 14 has a substantially rectangular flat plate shape, and has a length dimension in the left-right direction larger than the width dimension in the front-rear direction. The first member 14 is desirably made of a material having high heat conductivity, and is made of an aluminum alloy, stainless steel, or a copper alloy, for example. The first member 14 can be a clad plate prepared by stacking a brazing material on a base material, for example. If the first member 14 is the clad plate, the base material is made of an Al-Mn based aluminum alloy prepared by adding manganese to aluminum, and the brazing material is made of an Al-Si based aluminum alloy prepared by adding silicon to aluminum, for example. The first member 14 can also be a clad plate composed of a combination of a base material made of stainless steel and a brazing material made of a nickel alloy, for example. The clad plate can be obtained by a publicly-known manufacturing method such as adhesion between the base material and the brazing material or spraying of the brazing material onto the base material.

The second member 16 has an opened rectangular box shape including a recessed part 18 opened downward, and integrally includes an upper wall having a substantially rectangular flat plate shape, and a rectangular cylindrical peripheral wall protruding downward from an outer peripheral edge of the upper wall. The second member 16 is desirably made of a material having high heat conductivity like the first member 14, and is made of an aluminum alloy, stainless steel, or a copper alloy, for example.

The second member 16 has a left end portion provided with a supply hole 20 penetrating the upper wall of the recessed part 18 in the up-down direction, and a right end portion provided with a discharge hole 22 penetrating the upper wall of the recessed part 18 in the up-down direction. The second member 16 includes a substantially cylindrical supply port 24 provided at an opening periphery of the supply hole 20 and protruding upward from the upper wall of the recessed part 18, and a substantially cylindrical discharge port 26 provided at an opening periphery of the discharge hole 22 and protruding upward from the upper wall of the recessed part 18.

As depicted in FIGS 2 and 3, the first member 14 and the second member 16 are superposed on and fixed to each other in the up-down direction. A protruding tip surface at a peripheral wall of the recessed part 18 of the second member 16 is brought into abutting contact with an outer peripheral edge of the first member 14, and brazing is performed using the brazing material of the first member 14 configured as the clad plate, for example, thereby fixing the first member 14 and the second member 16 to each other. As a result of the described superposition and fixation between the first member 14 and the second member 16, the outer wall member 12 is formed by the first member 14 and the second member 16.

The opening of the recessed part 18 of the second member 16 is covered by the first member 14, thereby forming a cooling flow path 28 inside the outer wall member 12. The cooling flow path 28 is a flow path for causing a heat medium to flow therein that is composed of liquid such as water or ethylene glycol solution, or gas such as air, for example. The cooling flow path 28 is supplied with the heat medium at low temperature from the outside via the supply hole 20, and the heat medium brought to high temperature through heat exchange is discharged to the outside via the discharge hole 22. To achieve this, the supply hole 20 is provided at an upstream-side end of the cooling flow path 28, and the discharge hole 22 is provided at a downstream-side end of the cooling flow path 28. As the cooling flow path 28 for flow of the heat medium is formed inside the outer wall member 12, a joint part between the first member 14 and the second member 16 has a fluid or liquid tightness capable of preventing leakage of the heat medium.

The outer wall member 12 is provided with a pair of cooling walls 30, 30. Specifically, a part of the first member 14 forming a wall of the cooling flow path 28 corresponds to the cooling wall 30 on a lower side. The bottom wall of the recessed part 18 of the second member 16 corresponds to the cooling wall 30 on an upper side. Thus, parts of the outer wall member 12 facing each other in the up-down direction correspond to the pair of cooling walls 30, 30. The cooling walls 30, 30 are cooled through heat exchange with the heat medium flowing in the cooling flow path 28. Respective upper and lower outer surfaces of the cooling walls 30, 30 are planes extending substantially orthogonal to the up-down direction, and these upper and lower outer surfaces function as cooling surfaces 32.

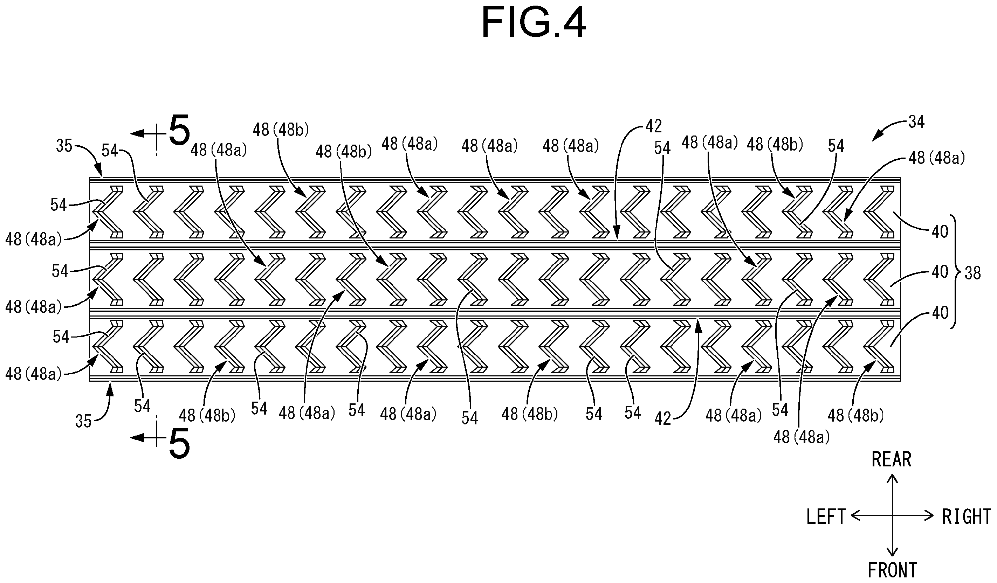

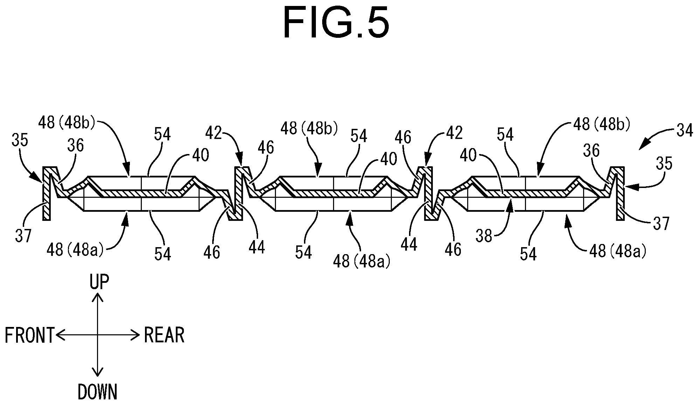

An inner fin 34 is housed in the cooling flow path 28 formed between respective facing surfaces of the first member 14 and the bottom wall of the recessed part 18 of the second member 16. As also depicted in FIGS. 4 and 5, the inner fin 34 has a substantially rectangular plate shape as a whole where a left-right dimension is larger than a front-rear width dimension. The inner fin 34 is made of metal such as an aluminum alloy or stainless steel, or synthetic resin, for example. The inner fin 34 of the present practical embodiment is a pressed fitting made of an aluminum alloy. The inner fin 34 is preferably made of a material having high heat conductivity like the first and second members 14 and 16. The inner fin 34 has a shape and a size allowing the inner fin 34 to be inserted into the recessed part 18 of the second member 16.

An edge wall 35 protruding in the up-down direction is provided at each end in the front-rear direction of the inner fin 34. The edge wall 35 is folded back downward at the end of the upward protrusion and then protrudes downward, thereby protruding to both upper and lower sides. More specifically, the edge wall 35 integrally includes an edge wall coupler 36 protruding upward, and an edge wall body 37 extending after being folded back downward from an upper end of the edge wall coupler 36. The edge wall coupler 36 is inclined in a direction away from the edge wall body 37 in the front-rear direction. The edge wall body 37 is substantially not inclined in the up-down direction. The edge wall body 37 extends to a position lower than a lower end of the edge wall coupler 36. The edge wall 35 may be provided in such a way that the edge wall coupler 36 protrudes downward, and the edge wall body 37 extends upward from the lower end of the edge wall coupler 36.

A middle separator 38 is provided between the edge walls 35, 35 of the inner fin 34. The middle separator 38 is integrally continuous with the edge wall coupler 36 at inner side ends of the edge wall coupler 36 in the front-rear direction. The edge wall 35 protrudes to both sides in the up-down direction with respect to the middle separator 38. The middle separator 38 is located at a middle position in the up-down direction with respect to the edge wall body 37, and extends in a substantially orthogonal direction to the up-down direction. The middle separator 38 of the present practical embodiment is partitioned into three projection forming parts 40, 40, 40 by two partition walls 42, 42 described later.

At the inner fin 34, the two partition walls 42, 42 protruding to both sides in the up-down direction from the middle separator 38 are provided at middle positions in the front-rear direction of the middle separator 38. The partition wall 42 integrally includes a partition wall body 44 protruding to both sides in the up-down direction from the middle separator 38, and a pair of partition wall couplers 46, 46 forming connection between upper and lower ends of the partition wall body 44 and the middle separator 38. The partition wall body 44 is formed continuously over an entire length in the left-right direction of the inner fin 34, and is substantially not inclined with respect to the up-down direction. The partition wall coupler 46 is formed continuously over the entire length in the left-right direction of the inner fin 34, and extends after being folded back inward in the up-down direction from each of upper and lower ends of the partition wall body 44. The partition wall coupler 46 is inclined in a direction away from the partition wall body 44 in the front-rear direction. The partition wall couplers 46, 46 extending from the upper and lower ends of the partition wall body 44 are respectively connected to one and the other of the two projection forming parts 40, 40 next to each other in the front-rear direction. These two projection forming parts 40, 40 are continuous integrally with each other by the partition wall 42.

The projection forming parts 40, 40, 40 of the middle separator 38 separated by the partition walls 42, 42 are each provided with a plurality of projections 48. As depicted in FIG. 4, the projection 48 has a substantially V-shape on the plane of the inner fin 34, has a substantially V-shape viewed in the up-down direction, and in a state with the inner fin 34 installed in the cooling flow path 28 described later, becomes narrower in the front-rear direction toward the left, which is an upstream side of the cooling flow path 28. The projection 48 has a left side portion on the upstream side of the cooling flow path 28 functioning as an upstream-side inclined surface 50 as an upstream inclined part inclined in a position of increasing a jutting height dimension toward a downstream side, and a right side portion on the downstream side of the cooling flow path 28 functioning as a downstream-side inclined surface 52 as a downstream inclined part inclined in a position of reducing a jutting height dimension toward the downstream side. As a result, in a center part in the left-right direction of the projection 48, which is a connection part between the upstream-side inclined surface 50 and the downstream-side inclined surface 52, a ridge line 54 having a maximum jutting height dimension is formed continuously in a substantially V-shape viewed in the up-down direction.

The projection 48 includes a plurality of the projections 48 arranged at substantially uniform spacings in the left-right direction. In the projection forming parts 40, 40, 40, the same number of first projections 48a (described later) are formed at substantially the same positions in the left-right direction. The same number of second projections 48b (described later) are formed at substantially the same positions in the left-right direction. The projections 48 are provided over a substantially entire length of the middle separator 38 in the left-right direction. The projections 48 are provided in a scattering pattern in a region extending substantially entirely in the front-left direction of the projection forming part 40. In the present practical embodiment, the projection 48 is slightly spaced apart from the edge walls 35, 35 and the partition walls 42, 42 in the front-rear direction to generate parts without the projection 48 at front and rear ends of the projection forming part 40. Thus, during molding of the edge walls 35, 35 and the partition walls 42, 42 by press working, it is possible to prevent the projection 48 from hindering the molding of the edge walls 35, 35 and the partition walls 42, 42. The projection 48 may be provided continuously over the width direction of the projection forming part 40 (front-rear direction) entirely, and the respective ends of the projection 48 may be directly connected to the partition walls 42 or to the partition wall 42 and the edge wall 35.

As depicted in FIGS. 2 and 5, the projection 48 includes the first projection 48a jutting out from a lower surface of the middle separator 38, and the second projection 48b jutting out from an upper surface of the middle separator 38. As depicted in FIG. 2, the first projection 48a and the second projection 48b are provided alternately in the left-right direction. While the first projection 48a and the second projection 48b of the present practical embodiment have shapes and sizes substantially the same between the first projection 48a and the second projection 48b and jut out to opposite directions, they may differ from each other in shape or size. While arrangement of the first projection 48a and the second projection 48b in the left-right direction is the same between the three projection forming parts 40, 40, 40 in the present practical embodiment, it may differ therebetween.

As depicted in FIGS. 1 to 3, the inner fin 34 is located between the first member 14 and the second member 16 one above the other, and is housed in the cooling flow path 28 forming an internal region of the outer wall member 12 as depicted in FIGS. 2 and 3. The length dimension of the inner fin 34 in the left-right direction is smaller than the length dimension of the cooling flow path 28 in the left-right direction, and left and right both end surfaces of the inner fin 34 are spaced apart from the outer wall member 12 inward in the left-right direction. Specifically, the inner fin 34 is arranged partially in a flow path length direction of the cooling flow path 28, and is located in a substantially center area of the cooling flow path 28. Thus, in the present practical embodiment, the internal region of the outer wall member 12 separated into two by the inner fin 34 is, more specifically, defined in a center part in the left-right direction except both ends in the left-right direction of the cooling flow path 28. In the present practical embodiment, the inner fin 34 is located on the inner side in the left-right direction with respect to the supply hole 20 and the discharge hole 22 formed at respective ends in the flow path length direction of the cooling flow path 28, and is provided without covering the supply hole 20 and the discharge hole 22.

The inner fin 34 may located into position with respect to the outer wall member 12 by fitting the edge walls 35, 35 to a side wall of the second member 16 in the front-rear direction, or may be located into position with respect to the outer wall member 12 by interposing at least one of the edge walls 35, 35 and the partition walls 42, 42 between the first member 14 and the bottom wall of the second member 16. A positioning structure other than the edge walls 35, 35 and the partition walls 42, 42 may be provided between the inner fin 34 and the outer wall member 12. More specifically, by providing at least one of the bottom wall and the side wall of the second member 16 with protrusions to be engaged with left and right end surfaces of the inner fin 34 in the left-right direction, for example, it becomes possible to locate the inner fin 34 into position with respect to the outer wall member 12 in each of the front-rear direction, the left-right direction, and the up-down direction without the need of fitting the edge walls 35, 35 to the recessed part 18 or interposing the edge walls 35, 35 and/or the partition walls 42, 42 between the first and second members 14 and 16. The inner fin 34 may be unfixed to the outer wall member 12, or at least one of the edge walls 35, 35 and the partition walls 42, 42 may be fixed to the outer wall member 12 by means such as adhesion or brazing, for example.

By arranging the inner fin 34 in the cooling flow path 28, the cooling flow path 28 is separated into two or more by the inner fin 34 in a middle part in the flow path length direction. Specifically, as the middle separator 38 of the inner fin 34 is located in the middle in the up-down direction from the edge walls 35, 35 and the partition walls 42, 42, the middle separator 38 is spaced apart from both the cooling walls 30, 30. By so doing, the cooling flow path 28 is separated by the inner fin 34 into two on both upper and lower sides. A region in the cooling flow path 28 on the lower side with respect to the inner fin 34 is a region for cooling the cooling wall 30 of the first member 14. A region in the cooling flow path 28 on the upper side with respect to the inner fin 34 is a region for cooling the cooling wall 30 of the second member 16.

In the cooling heat exchanger 10 having a double-sided cooling configuration where the cooling surfaces 32 are provided on the respective upper and lower surfaces by separating the cooling flow path 28 into two on both upper and lower sides using the middle separator 38, a flow path cross-sectional area is adjusted in a region on each of the upper and lower sides of the cooling flow path 28 for cooling the cooling surfaces 32, 32 (cooling walls 30, 30), thereby facilitating control over the flow rate and flow velocity of the heat medium.

By arranging the inner fin 34 in the middle part in the flow path length direction of the cooling flow path 28, both ends in the flow path length direction of the cooling flow path 28 provided with the supply hole 20 and the discharge hole 22 are not partitioned into upper and lower parts by the inner fin 34. Thus, after the heat medium is supplied from the supply hole 20 into the cooling flow path 28, the heat medium flows into both upper and lower regions of the cooling flow path 28 without being hindered by the inner fin 34. Furthermore, after the heat medium passes through any of the upper and lower regions in the cooling flow path 28, the heat medium is also discharged to the outside from the discharge hole 22 without being hindered by the inner fin 34.

The regions in the cooling flow path 28 on both upper and lower sides with respect to the inner fin 34 are each separated into three in the front-rear direction by the two partition walls 42, 42. By so doing, the cooling flow path 28 is separated into six flow path parts 56, 56, ..., 56 for causing the heat medium to flow therein in the same direction, and these six flow path parts 56, 56, ..., 56 provided in parallel form a parallel flow path portion 58 of the present practical embodiment.

As described above, by separating each of the regions in the cooling flow path 28 on both upper and lower sides into three in the flow path width direction using the partition walls 42, 42, it becomes possible to control the flow rate and flow velocity of the heat medium appropriately flowing in each of the flow path parts 56, and also possible to set the sizes of the cooling surfaces 32, 32 in the flow path width direction with a higher degree of freedom to be subjected to cooling action by these flow path parts 56.

As depicted in FIGS. 2 and 3, one of the first projection 48a and the second projection 48b juts out from the middle separator 38 of the inner fin 34 into each flow path part 56. The first projection 48a is spaced apart upward from the cooling wall 30 on the lower side. A first narrow flow path 60a where a flow path cross-sectional area is smaller than the other part in the flow path part 56 on the lower side is formed between the first projection 48a and the cooling wall 30 on the lower side. The second projection 48b is spaced apart downward from the cooling wall 30 on the upper side. A second narrow flow path 60b where a flow path cross-sectional area is smaller than the other part in the flow path part 56 on the upper side is formed between the second projection 48b and the cooling wall 30 on the upper side. The first narrow flow path 60a and the second narrow flow path 60b of the present practical embodiment have substantially the same flow path cross-sectional areas and substantially the same flow path cross-sectional shapes, they may differ from each other in flow path cross-sectional area and flow path cross-sectional shape.

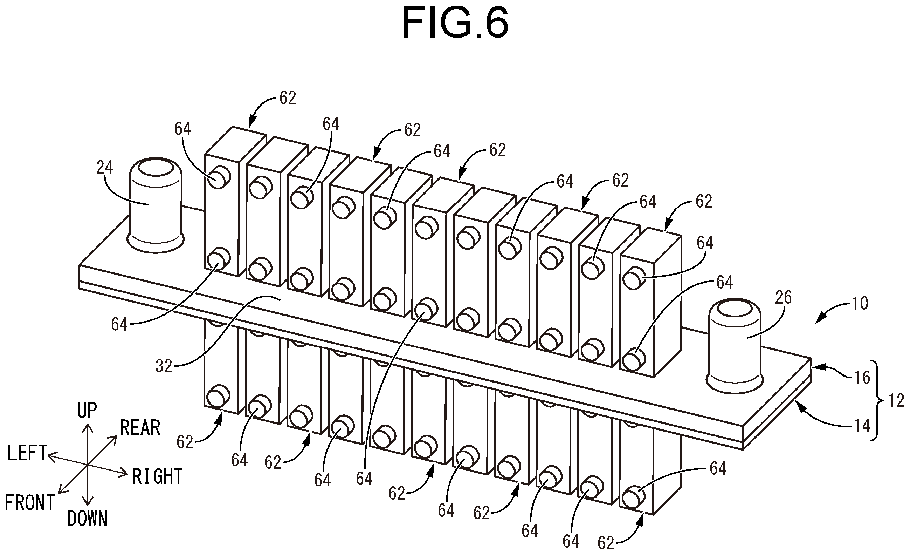

As depicted in FIG. 6, battery packs 62 as cooling targets are mounted on the cooling heat exchanger 10 having the above configuration. The battery pack 62 is a battery to be used in a motorized vehicle such as an electric car or a hybrid car, for example. The battery pack 62 has a substantially rectangular solid outer shape as a whole, for example, and has a front-rear width dimension larger than a left-right length dimension. A terminal part 64 protruding frontward is provided at each of upper and lower ends of the battery pack 62. The terminal part 64 is an output terminal for outputting a large current via a bus bar not depicted in the drawings. Thus, the battery pack 62 of the present practical embodiment in a used state is likely to be brought to higher temperature at each of the upper and lower ends with the terminal parts 64 than at an upper-lower center part.

As the cooling heat exchanger 10 has a double-sided cooling configuration where the cooling surfaces 32 are provided on the respective upper and lower surfaces, the battery pack 62 is superposed on each of the cooling surfaces 32, 32 on the respective upper and lower sides of the cooling heat exchanger 10. In the present practical embodiment, a plurality of the battery packs 62 are mounted on each of the upper and lower sides of the cooling heat exchanger 10 and arranged along the left-right direction, which is the flow path length direction of the cooling flow path 28, and these battery packs 62 are superposed on each of the cooling surfaces 32, 32.

In the cooling heat exchanger 10, as a result of heat exchange between the cooling heat medium flowing in the cooling flow path 28 and the cooling walls 30, 30 of the first and second members 14 and 16, the cooling surfaces 32, 32 defined on the respective surfaces of the cooling walls 30, 30 are brought to low temperature. The battery pack 62 to generate heat during operation is placed on each of the cooling surfaces 32, 32, and heat is exchanged between each of the first and second members 14 and 16 including the cooling surfaces 32, 32 and the battery pack 62 superposed on each cooling surface 32, thereby cooling the battery pack 62. In other words, heat is exchanged between the battery pack 62 and the heat medium flowing in the cooling flow path 28 via each of the first and second members 14 and 16, thereby cooling the battery pack 62.

The inner fin 34 is arranged in the cooling flow path 28, and the inner fin 34 is in contact with the outer wall member 12 (first and second members 14 and 16). Thus, a substantial contact area between the outer wall member 12 and the heat medium is increased by the inner fin 34, thereby cooling the cooling surfaces 32, 32 with the heat medium efficiently.

The heat medium increases in temperature in response to receipt of heat from the battery pack 62. In particular, the heat medium flowing through a position closer to each of the cooling walls 30, 30 is warmed with heat from the battery pack 62 to increase in temperature. On the other hand, the heat medium flowing through a position farther from each of the cooling walls 30, 30, in other words, the heat medium flowing through a position closer to the inner fin 34 is unlikely to be affected by heat from the battery pack 62 and is maintained easily at low temperature as temperature increase thereof is suppressed comparatively. By so doing, a temperature distribution where a temperature becomes higher toward both upper and lower sides is generated easily in the heat medium in the cooling flow path 28 through heat exchange with the battery pack 62. As a result, a temperature difference is reduced between the heat medium at high temperature flowing near each of the cooling walls 30, 30 and the battery pack 62, reducing efficiency in heat exchange between the battery pack 62 and the heat medium.

In response to this, in the cooling heat exchanger 10, the inner fin 34 is provided with the first and second projections 48a and 48b jutting out into the cooling flow path 28 and the heat medium is stirred in climbing over the first and second projections 48a and 48b, thereby reducing a temperature difference of the heat medium in the up-down direction. By so doing, only the heat medium flowing near the battery pack 62 is prevented from being brought to high temperature to ensure a large temperature difference between the battery pack 62 and the heat medium flowing near the battery pack 62, making it possible to improve efficiency in heat exchanger between the battery pack 62 and the heat medium.

In the present practical embodiment, the inner fin 34 is formed with the first and second projections 48a and 48b formed over the inner fin 34 substantially entirely in the left-right direction. Thus, in the parallel flow path portion 58 defined by the inner fin 34, action of stirring the heat medium using the first and second projections 48a and 48b is fulfilled, so that the battery pack 62 is cooled efficiently by the heat medium flowing in the parallel flow path portion 58. In the cooling heat exchanger 10 of the present practical embodiment, the inner fin 34 extends outward to both sides in the left-right direction beyond the region where the battery pack 62 is superposed. Thus, the effect of improving heat exchange efficiency using the inner fin 34 works effectively on all the battery packs 62.

The projection 48 of the present practical embodiment has a V-shape on the plane of the inner fin 34 that becomes narrower toward the upstream side of the flow path part 56. Specifically, the projection 48 has a V-shape in a plan view. In climbing over the projection 48, the heat medium tries to flow in a direction orthogonal to the projection 48 where a flow resistance is low, so that the heat medium flows in a direction inclined toward an inside of the flow path width direction from the flow path length direction (left-right direction) of the flow path part 56. Flows of the heat medium toward the inside of the flow path width direction join each other on the downstream side with respect to the projection 48. This generates a vortex flow or a turbulent flow on the downstream side with respect to the projection 48 to stir the heat medium by the vortex flow or the turbulent flow. By so doing, a temperature difference of the heat medium is reduced in the up-down direction, thereby suppressing cooling performance reduction to be caused by warming of the heat medium by the battery pack 62.

The battery pack 62 may be deformed in such a way as to cause a bulge of a surface thereof in response to heat generation during its use. In this case, the cooling walls 30, 30 with the cooling surfaces 32, 32 are elastically deformable in conformity with the deformation of the battery pack 62. Specifically, the cooling walls 30, 30 having flat plate shapes are elastically deformable by deflection, and each partition wall 42 of the inner fin 34 superposed on the cooling walls 30, 30 from the side of the cooling flow path 28 is elastically deformable by deflection in at least one of the partition wall body 44 and the partition wall couplers 46, 46. Thus, if the surface of the battery pack 62 is deformed by bulging toward the cooling surface 32 to press the cooling surface 32 toward the cooling flow path 28 side, the cooling wall 30 including the cooling surface 32 becomes elastically deformed by deflection without being hindered by the partition wall 42 of the inner fin 34. Deforming the cooling surface 32 elastically in conformity with the deformation of the surface of the battery pack 62 in this way prevents the occurrence of a clearance between respective superposed surfaces of the cooling surface 32 and the battery pack 62, plastic deformation of the first and second members 14 and 16 including the cooling walls 30, 30, plastic deformation of the inner fin 34, and others. As understood from above, in the inner fin 34 of the present practical embodiment, the partition walls 42, 42 are configured as elastically-deformable parts to be deformed elastically to allow approach between the cooling walls 30, 30 by elastic deformation thereof (approach by deformation).

By making the partition walls 42, 42 elastically deformable by deflection, if the up-down height dimensions of the partition walls 42, 42 become slightly larger than the depth of the recessed part 18 by an error, for example, it is still possible to accommodate the partition walls 42, 42 within the cooling flow path 28 through elastic deformations by deflection of the partition walls 42, 42. In the present practical embodiment, the edge walls 35, 35 of the inner fin 34 are elastically deformable by deflection like the partition walls 42, 42. Thus, failing to accommodate the edge walls 35, 35 within the cooling flow path 28 is also avoided. As a result, while a dimensional difference between the second member 16 and the inner fin 34 resulting from a tolerance is allowed, it is further possible to employ a configuration where the inner fin 34 is interposed and supported between the cooling walls 30, 30.

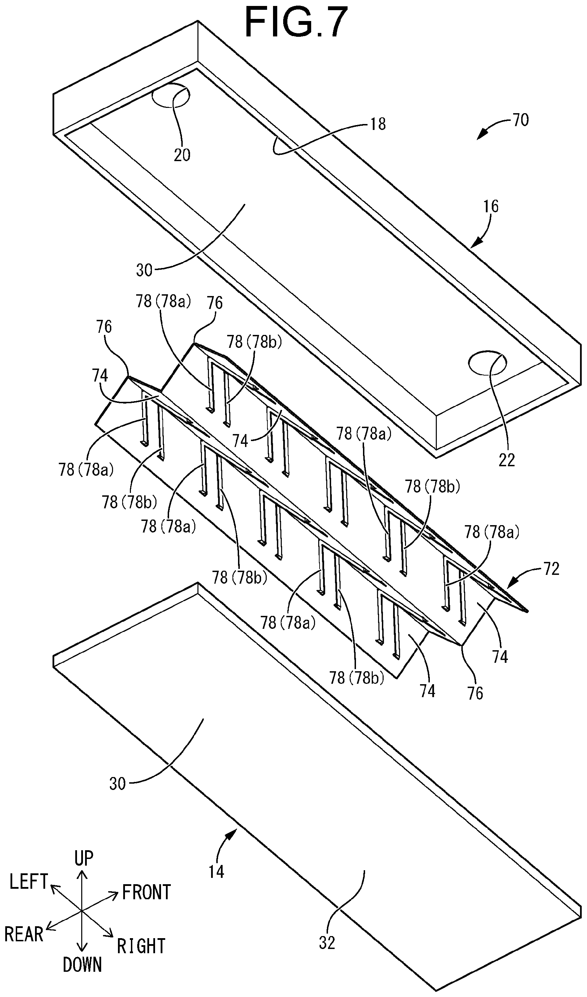

FIG. 7 depicts a cooling heat exchanger 70 according to a second practical embodiment of the present disclosure. The cooling heat exchanger 70 has a configuration where an inner fin 72 is arranged between the first member 14 and the second member 16. In the following, descriptions of members and parts substantially the same as those of the above practical embodiment will be omitted by indicating such members and parts using the same signs in the drawing.

The inner fin 72 is made of metal or synthetic resin, for example, and has a thin plate shape. The inner fin 72 has a cross section in the up-down direction folded back in a zigzag pattern or a wave pattern. In the present practical embodiment, the inner fin 72 has a zigzag cross section with a plurality of flat-plate shaped inclined plates 74 extending in an inclined pattern from the up-down direction and the front-rear direction and provided integrally and continuously in the front-rear direction at fold apexes 76. The zigzag cross-sectional shape of the inner fin 72 extends linearly in the left-right direction. The number of folds of the inner fin 72 having a zigzag pattern or a wave pattern (the number of the apexes 76) is not particularly limited but is set appropriately with consideration for the width dimension of the cooling surface, a flow path cross-sectional area of the flow path part defined by the inner fin 72, and others, for example.

The inner fin 72 is formed with a projection 78. The projection 78 has a substantially V-shape on the plane of the inner fin 72, and has a tapered shape (becomes narrower) toward an upstream side of a cooling flow path. Specifically, the projection 78 has a substantially V-shape viewed in the up-down direction. The projection 78 is composed of a first projection 78a jutting out on an upper surface side of the inner fin 72, and a second projection 78b jutting out on a lower surface side of the inner fin 72. The first projection 78a and the second projection 78b are arranged in a pair and located at positions spaced apart from each other and side by side in the left-right direction, which is a flow path length direction of the cooling flow path. In the present practical embodiment, the first projections 78a and the second projections 78b are arranged in two lines in the front-rear direction, which is a flow path width direction of the cooling flow path, and are arranged in five pairs in each of the lines. Thus, in the inner fin 72 of the present practical embodiment, ten first projections 78a and ten second projections 78b are formed.

The V-shape projection 78 is formed in such a way that a narrowed upstream-side end is located on the apex 76 of the zigzag of the inner fin 72 where the inclined plates 74, 74 are continuous with each other. A downstream-side end of the V-shape projection 78 does not reach an end of the inclined plate 74, so that the projections 78, 78 next to each other in the front-rear direction are spaced apart from each other in the front-rear direction. The projection 78 may be provided in such a way as to reach the apex 76 or may be provided in a part shifted from the apex 76. The projection 78 is simply required to be provided at least at the inclined plate 74 between the apexes 76, 76 next to each other. Meanwhile, the projection 78 is desirably formed further at the inclined plate 74 between an end in the front-rear direction of the inner fin 72 and the apex 76 next to this end.

In the present practical embodiment, the inner fin 72 is a pressed fitting and the projection 78 is formed by press working, so that a V-shape recess is formed on a surface of the inner fin 72 on a side opposite to a jutting side of the projection 78. By forming the projection 78 simultaneously with molding of a flat-plate shape metal raw plate into the zigzag cross section by press working, it becomes possible to reduce the number of processing steps.

In the cooling heat exchanger 70 having the inner fin 72 described above, the cooling flow path not depicted in the drawings formed between the first member 14 and the second member 16 is separated by the inner fin 72 in the up-down direction, which is a flow path height direction. Furthermore, as a result of the cross-sectional shape of the inner fin 72 folded back in the zigzag pattern, superposing the fold apex 76 on the first member 14 or the second member 16 further separates the cooling flow path into two or more in the front-rear direction, which is the flow path width direction. As a result, the cooling surfaces 32 provided on the respective upper and lower outer surfaces of the first member 14 and the second member 16 are cooled effectively by the separated flow path parts of the cooling flow path.

The inner fin 72 of the present practical embodiment having a simpler shape than the inner fin 34 of the first practical embodiment allows the cooling flow path to be partitioned between upper and lower sides and further allows the cooling flow path to be partitioned in the flow path width direction, making it possible to encourage improvement in cooling performance. The inner fin 72 may be arranged in an unfixed state between the first member 14 and the second member 16, or the apex 76 and both front and rear ends of the inner fin 72 may be fixed to the first and second members 14 and 16.

Furthermore, as the first and second projections 78a and 78b jutting out into flow path regions of the cooling flow path are provided at the inner fin 72, the heat medium flowing in these flow path regions are stirred by the first and second projections 78a and 78b. This prevents only the heat medium flowing through a position near each of the cooling surfaces 32 from being brought to high temperature, making it possible to encourage improvement in cooling performance.

If the cooling walls 30, 30 are deformed in a direction of approaching each other by the action of pressing force from a battery pack, for example, the inner fin 72 becomes capable of allowing the deformations of the cooling walls 30, 30 through elastic deformation by deflection of each inclined plate 74, etc. In this way, the inclined plate 74 functions as an elastically-deformable part, thereby encouraging improvement in the performance of the respective cooling surfaces 32 provided at the cooling walls 30, 30 in making conformity with the battery pack or encouraging prevention of unintended plastic deformation due to input from the outside.

The inner fin 72 having the zigzag cross section is depicted as an example in FIG. 7. Meanwhile, it is also possible to employ an inner fin having a wave-pattern cross section that is an entirely curved cross section without the flat-plate shape inclined plate 74, for example.

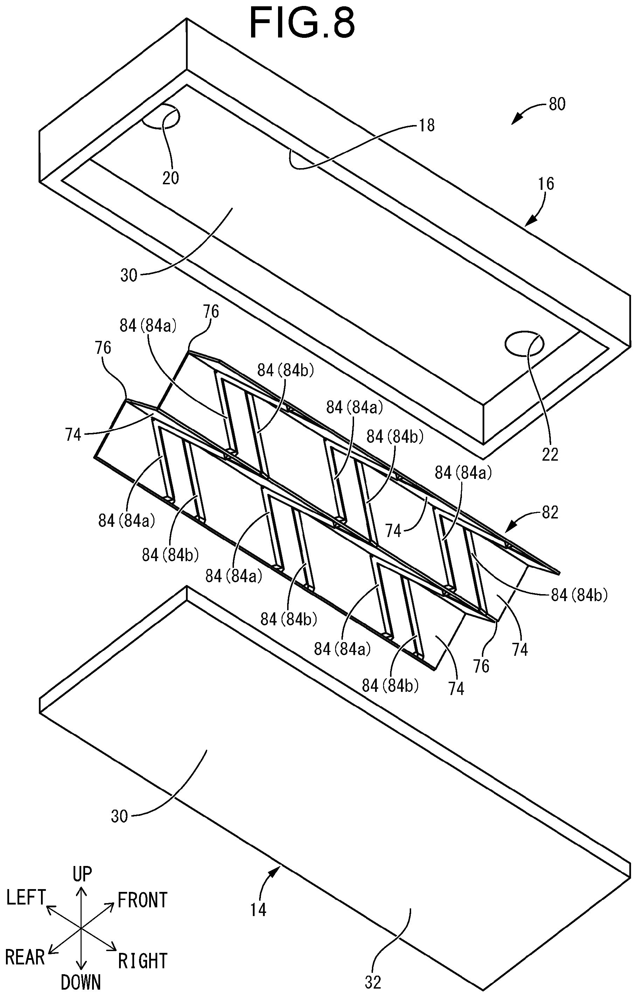

FIG. 8 depicts a cooling heat exchanger 80 according to a third practical embodiment of the present disclosure. The cooling heat exchanger 80 has a configuration where an inner fin 82 is arranged between the first member 14 and the second member 16.

Like the inner fin 72 of the second practical embodiment, the inner fin 82 is a plate-like member having a cross section in a zigzag pattern or a wave pattern. The inner fin 82 is provided with a projection 84 (first projection 84a and second projection 84b) having a different size from the inner fin 72 of the second practical embodiment. The projection 84 of the present practical embodiment has a V-shape similar to that of the projection 78 of the second practical embodiment, is provided continuously and entirely in the front-rear direction of the inclined plate 74, and has a downstream-side end reaching as far as front-rear ends of the inclined plate 74.

As shown in the present practical embodiment, the projections 84 may be formed substantially entirely over the inner fin 82 in a flow path width direction of a cooling flow path. While the projection 84 may be provided to reach as far as the fold apex 76 of the inner fin 82, it is preferably provided in a part shifted from the apex 76 to encourage facilitation of processing.

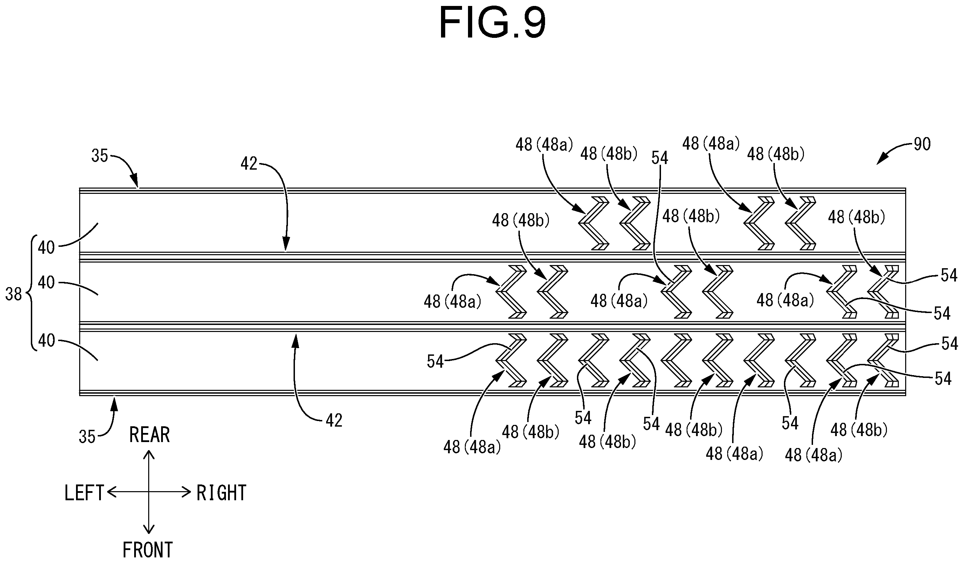

FIG. 9 depicts an inner fin 90 forming a cooling heat exchanger according to a fourth practical embodiment of the present disclosure. The inner fin 90 of the present practical embodiment can be employed in place of the inner fin 34 of the first practical embodiment. Thus, in the following, members and parts substantially the same as those of the first practical embodiment will be given the same signs as those of the first practical embodiment for facilitating understanding.

The middle separator 38 of the inner fin 90 (projection forming parts 40, 40, 40) is formed with the plurality of projections 48 (first projection 48a and second projection 48b). In the present practical embodiment, the projection 48 is not provided in a left side part of the inner fin 90 located on the upstream side of the cooling flow path 28 but is provided only in a right side part of the inner fin 90 located on the downstream side of the cooling flow path 28. By so doing, action of disturbing the flow of the heat medium using the projection 48 works more intensely on the downstream side than on the upstream side of the cooling flow path 28, and regions where the action of disturbing the flow of the heat medium works differently from each other are defined at different positions in a flow path length direction of the cooling flow path 28.

In the present practical embodiment, the number of the formed projections 48 and arrangement thereof differ between the three projection forming parts 40, 40, 40. More specifically, the number of the formed projections 48 becomes larger and spacings between the projections 48 in the flow path length direction decrease in the projection forming part 40 closer to the front in a flow path width direction of the cooling flow path 28. By so doing, on a downstream side of the parallel flow path portion 58, the action of disturbing the flow of the heat medium using the projection 48 works more intensely in the flow path part 56 closer to the front, so that regions where the action of disturbing the flow of the heat medium works differently from each other are defined at different positions in the flow path width direction of the cooling flow path 28.

As described above, by employing the inner fin 90 according to the present practical embodiment, action of disturbing the flow of the heat medium to generate a vortex flow or a turbulent flow (turbulent flow facilitating action) is set partially differently in the parallel flow path portion 58. Thus, in a part where the turbulent flow facilitating action works intensely, high cooling performance is fulfilled to allow the battery pack 62 to be cooled efficiently.

In particular, in the present practical embodiment, the turbulent flow facilitating action works more intensely on the downstream side of the cooling flow path 28 (parallel flow path portion 58). Thus, by stirring the heat medium on the downstream side having been warmed in parts close to the cooling walls 30, 30 through heat exchange with the battery packs 62, it is possible to ensure effective cooling performance even on the downstream side. Moreover, in the present practical embodiment, as the turbulent flow facilitating action works more intensely at the front, it is possible to cool a front-side part of the battery pack 62 efficiently where a large amount of heat is likely to be generated for the presence of the terminal part 64.

The arrangement of the projections 48 shown in the present practical embodiment is merely an example, and can be changed, as appropriately, with consideration for a way in which the battery pack 62 generates heat (temperature distribution), requested cooling performance, and others, for example. Furthermore, the turbulent flow facilitating action using the projection 48 works differently in response not only to the number or arrangement of the projections 48 but also to the size of the projection 48 including its height, the shape of the projection 48, a frictional resistance on a surface of the projection 48, etc. Thus, it is further possible to define the regions where the turbulent flow facilitating action works differently from each other on the basis of a difference in size, etc. of the projection 48.

If the regions where the turbulent flow facilitating action works differently from each other are required to be defined only for the battery pack 62 superposed on one of the cooling surfaces 32, for example, only one of the first projection 48a and the second projection 48b may be a projection to be used for defining the regions where the turbulent flow facilitating action works differently from each other on the basis of a difference in the arrangement or the number of the projections 48, the shape, size, surface frictional resistance, etc. of the projection 48 such as those shown in the present practical embodiment.

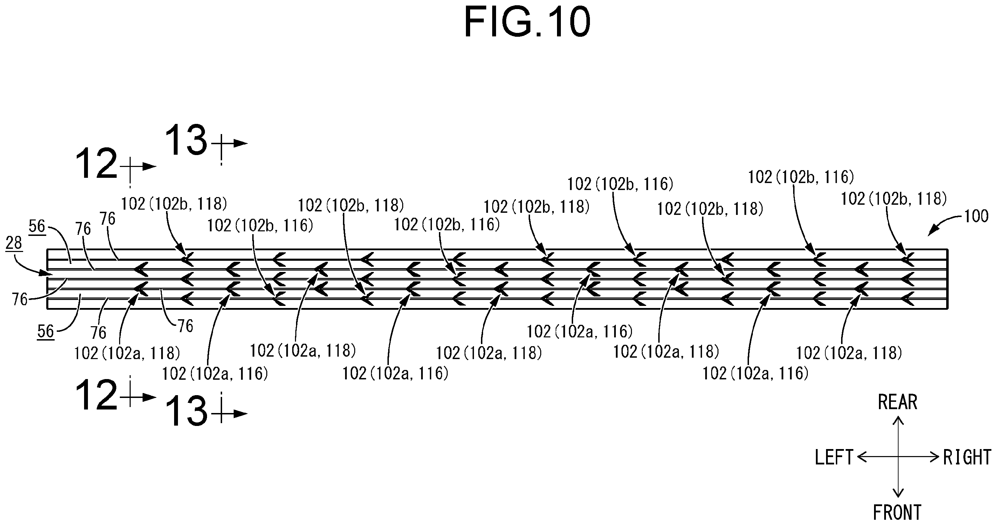

FIGS. 10 to 13 depict an inner fin 100 forming a cooling heat exchanger according to a fifth practical embodiment of the present disclosure. The inner fin 100 of the present practical embodiment can be employed in place of the inner fin 72 of the second practical embodiment. A left side in FIG. 10 corresponds to an upstream side of a cooling flow path, and a right side in FIG. 10 corresponds to a downstream side of the cooling flow path.

The inner fin 100 has a thin plate shape made of metal or synthetic resin, for example. Like the inner fin 72 of the second practical embodiment, the inner fin 100 has a cross-sectional shape folded back in a zigzag pattern or a wave pattern, and extends in the left-right direction. The inner fin 100 of the present practical embodiment is a pressed fitting.

The inner fin 100 is formed with a projection 102. The projection 102 extends in a substantially V-shape on the plane of the inner fin 100, and is tapered (becomes narrower) toward the upstream side of the cooling flow path. The projection 102 has a substantially V-shape viewed in the up-down direction. The projection 102 is composed of a first projection 102a jutting out on an upper surface side of the inner fin 100, and a second projection 102b jutting out on a lower surface side of the inner fin 100.

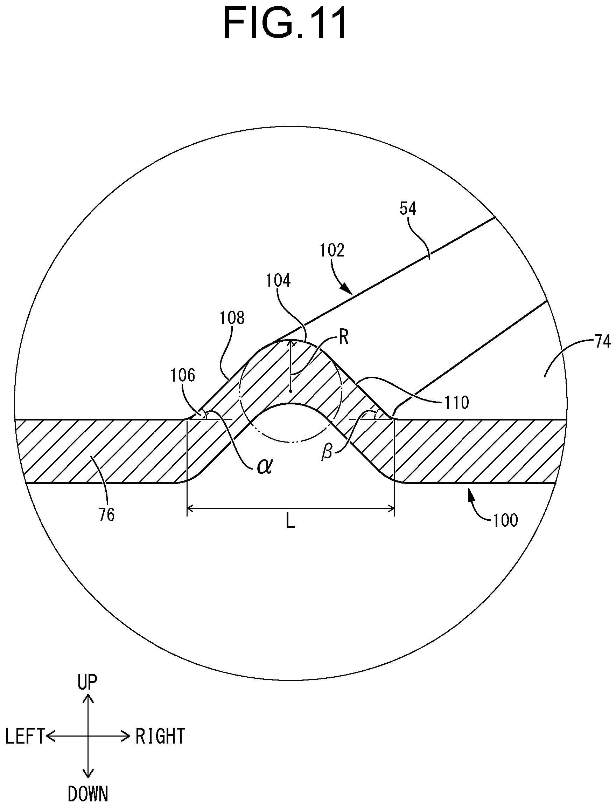

FIG. 11 depicts a cross section of one projection 102 in a flow path length direction in an enlarged manner. In the cross section depicted in FIG. 11, the projection 102 has a tapered cross-sectional shape that becomes narrower toward a jutting tip in the flow path length direction. More specifically, in the cross section depicted in FIG. 11, the projection 102 has a continuous outer shape in cross section including a projection apex 104 curved in an arc pattern, an upstream inclined part 108 extending upstream in an inclined pattern from an upstream-side end of the projection apex 104 toward a projection base 106 (an end of the projection 102 connected to the inclined plate 74), and a downstream inclined part 110 extending downstream in an inclined pattern from a downstream-side end of the projection apex 104 toward the projection base 106. The cross section of the projection 102 depicted in FIG. 11 is a cross section in the flow path length direction passing through a center in a flow path width direction. Meanwhile, any cross section of the projection 102 orthogonal to the ridge line 54 has a cross-sectional shape similar to that of FIG. 11, and description referring to FIG. 11 in terms of a numerical value range, etc. is preferably applicable in the same way to any cross section orthogonal to the ridge line 54.

In the cross section in the flow path length direction depicted in FIG. 11, with respect to a length dimension L of the projection base 106 in the flow path length direction, the projection apex 104 including the ridge line 54 has a radius of curvature R within a range from 0.05 to 1.5 times, more preferably, within a range from 0.2 to 1.45 times. By setting the radius of curvature R of the projection apex 104 equal to or greater than 0.05 times the length dimension L of the projection base 106, the projection apex 104 is formed into a cross section having a smooth arc pattern without forming a substantial corner. Furthermore, by setting the radius of curvature R of the projection apex 104 equal to or less than 1.5 times the length dimension L of the projection base 106, it becomes possible to prevent the length dimension of the projection 102 from increasing excessively in the flow path length direction and also possible to set respective inclination angles α and β sufficiently large for the upstream inclined part 108 and the downstream inclined part 110, which are smoothly continuous with the projection apex 104. In the present practical embodiment, the radius of curvature R of the projection apex 104 is within a range from 0.05 to 0.5 times the length dimension L of the projection base 106.

While the upstream inclined part 108 may have a curved shape, it has a linear shape in the present practical embodiment. An upper end of the upstream inclined part 108 extends in a tangential direction from the upstream-side end of the projection apex 104, and is continuous with the projection apex 104 smoothly without a corner. A lower end of the upstream inclined part 108 may be curved in an arc pattern, and in this case, it is desirably continuous with the inclined plate 74 forming a bottom surface of the cooling flow path 28 smoothly without a corner.

The inclination angle α of the upstream inclined part 108 with respect to the inclined plate 74 forming the bottom surface of the cooling flow path 28 is within a range from 20° to 70°, more preferably, within a range from 30° to 60°. If the upstream inclined part 108 has a curved shape, the inclination angle α of the upstream inclined part 108 with respect to the inclined plate 74 can be grasped as an average of inclination angles of the upstream inclined part 108 with respect to the inclined plate 74, for example.

By setting the inclination angle α of the upstream inclined part 108 equal to or greater than 20°, a flow of the heat medium from the upstream side toward the projection 102 is disturbed effectively by the upstream inclined part 108 forming a sufficiently large angle with respect to the flow direction of the heat medium, thereby encouraging improvement in cooling performance by the stirring action. Furthermore, by setting the inclination angle α of the upstream inclined part 108 equal to or less than 70°, it becomes possible to prevent the flow of the heat medium from being restricted excessively by the projection 102.

While the downstream inclined part 110 may have a curved shape, it has a linear shape in the present practical embodiment. An upper end of the downstream inclined part 110 extends in a tangential direction from the downstream-side end of the projection apex 104, and is continuous with the projection apex 104 smoothly without a corner. A lower end of the downstream inclined part 110 may be curved in an arc pattern, and in this case, it is desirably continuous with the inclined plate 74 forming the bottom surface of the cooling flow path 28 smoothly without a corner.

The inclination angle β of the downstream inclined part 110 with respect to the inclined plate 74 forming the bottom surface of the cooling flow path 28 is within a range from 20° to 70°, more preferably, within a range from 30° to 60°. If the downstream inclined part 110 has a curved shape, the inclination angle β of the downstream inclined part 110 with respect to the inclined plate 74 can be grasped as an average of inclination angles of the downstream inclined part 110 with respect to the inclined plate 74, for example.

By setting the inclination angle β of the downstream inclined part 110 equal to or greater than 20°, the flow of the heat medium in climbing over the projection 102 becomes separated easily from the downstream inclined part 110. This encourages expectation for the effect of generating a disturbed flow such as a vortex flow easily on the downstream side with respect to the projection 102. Furthermore, by setting the inclination angle β of the downstream inclined part 110 equal to or less than 70°, a flow of the heat medium is also ensured along the downstream inclined part 110, thereby encouraging expectation for efficient stirring of the heat medium resulting from joining with the flow thereof having been separated from the downstream inclined part 110.

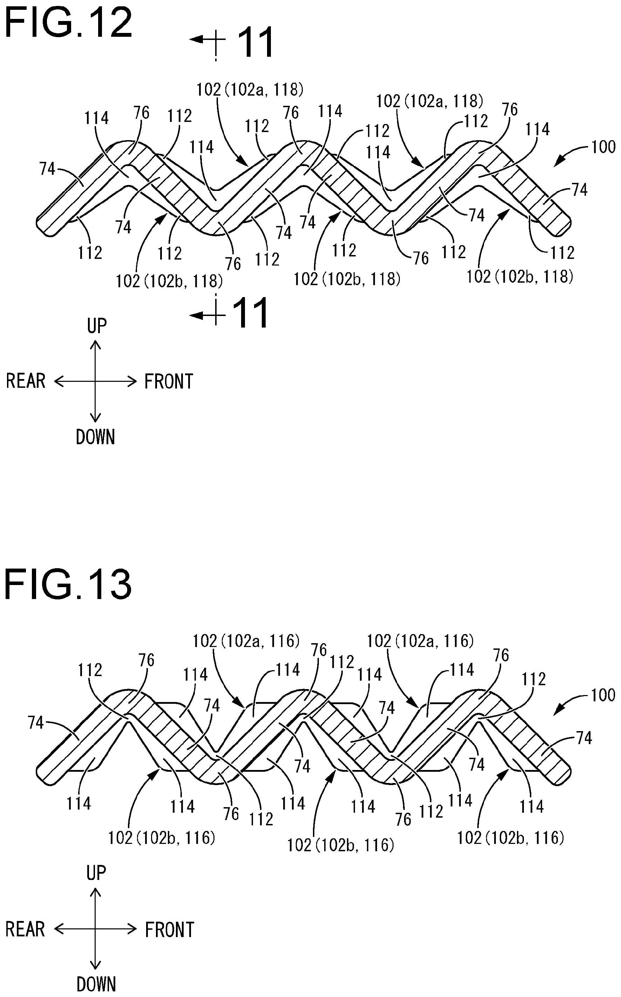

As depicted in FIGS. 12 and 13, the projection 102 of the present practical embodiment changes in jutting height dimension in the front-rear direction, which is the flow path width direction. A plurality of the projections 102 is composed of a center-low projection 116 including a low jutting portion 112 having a small jutting height formed at a front-rear center and a high jutting portion 114 having a large jutting height formed at front-rear each end, and a center-high projection 118 including the high jutting portion 114 having a large jutting height formed at a front-rear center and the low jutting portion 112 having a small jutting height formed at front-rear each end. Each of the first projection 102a and the second projection 102b has a configuration including a plurality of the center-low projections 116 and a plurality of the center-high projections 118. For better visibility, in each of FIGS. 12 and 13, only the projections 102 on the nearest side in a cross-sectional view are depicted.

As depicted in FIG. 10, each of a plurality of the first projections 102a and a plurality of the second projections 102b arranged along the flow path length direction includes the center-low projection 116 and the center-high projection 118 arranged alternately in the left-right direction, which is the flow path length direction. Thus, in a center part in the flow path width direction of the flow path part 56, the low jutting portion 112 of the center-low projection 116 and the high jutting portion 114 of the center-high projection 118 are arranged alternately in the flow path length direction. Furthermore, at both ends in the flow path width direction of the flow path part 56, the high jutting portions 114, 114 of the center-low projection 116 and the low jutting portions 112, 112 of the center-high projection 118 are arranged alternately in the flow path length direction.

According to the described inner fin 100 of the present practical embodiment, it is possible to achieve the action of stirring the heat medium more intensely at the high jutting portion 114 having a large jutting height dimension. It is further possible to reduce the flow resistance of the heat medium using the low jutting portion 112 having a small jutting height dimension, thereby encouraging pressure loss reduction.

In the present practical embodiment, the low jutting portion 112 and the high jutting portion 114 are arranged next to each other in the flow path length direction, and the heat medium having flowed through the low jutting portion 112 smoothly is stirred efficiently at the high jutting portion 114 on the downstream side with respect to this low jutting portion 112, thereby encouraging improvement in cooling performance efficiently. Furthermore, after a flow of the heat medium is disturbed strongly by the high jutting portion 114, the heat medium flows through the low jutting portion 112 on the downstream side with respect to this high jutting portion 114 relatively smoothly. This reduces the occurrence of a situation such as an interrupted flow.

The heat medium flows easily through the low jutting portion 112 where a flow resistance is smaller than at the high jutting portion 114. In this regard, by arranging the center-low projection 116 and the center-high projection 118 alternately in the flow path length direction, the low jutting portions 112 become located alternately in the flow path length direction at the center part and at each end in the flow path width direction. This further generates a flow of the heat medium in the flow path part 56 flowing in a meandering pattern in the flow path width direction in such a way as to link the low jutting portions 112 to each other, thereby further encouraging expectation for the effect of eliminating imbalance in a temperature distribution of the heat medium in the flow path width direction.

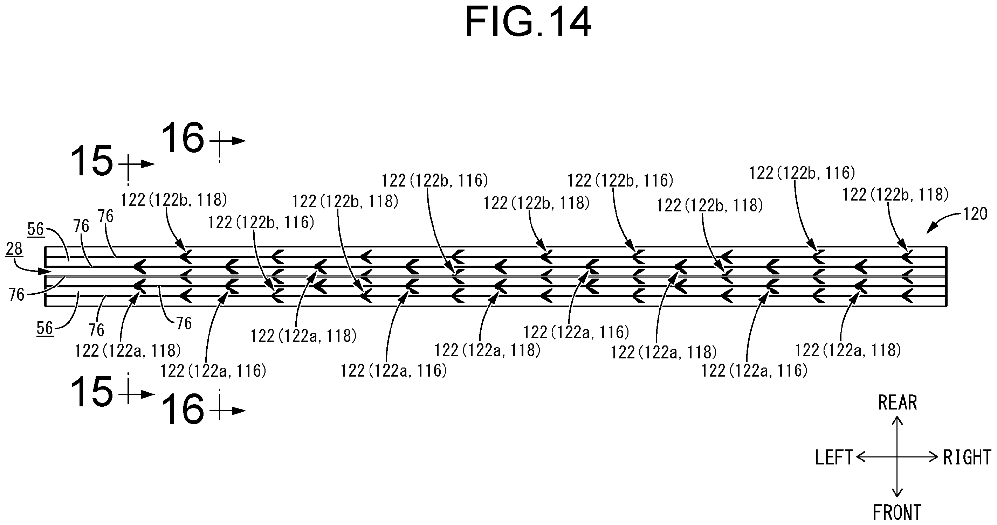

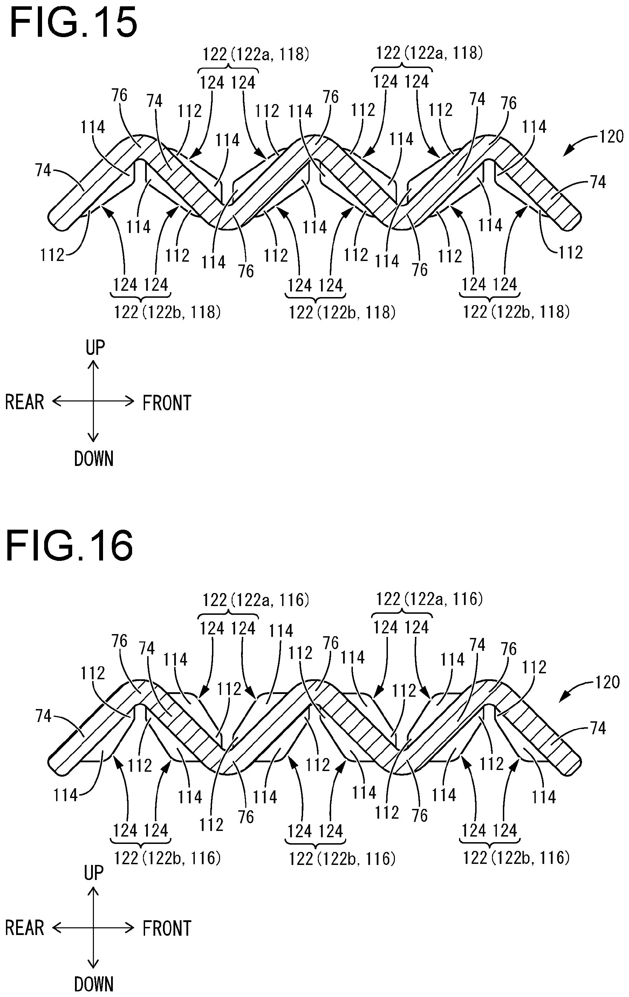

FIGS. 14 to 16 depict an inner fin 120 forming a cooling heat exchanger according to a sixth practical embodiment of the present disclosure. The inner fin 120 has a zigzag cross-sectional shape similar to that of the inner fin 100 of the fifth practical embodiment.

The inner fin 120 is provided with a projection 122. The projection 122 is composed of a plurality of first projections 122a jutting out from an upper surface of the inner fin 120, and a plurality of second projections 122b jutting out from a lower surface of the inner fin 120. While the projection 122 has a V-shape as a whole viewed in the up-down direction like the projection 102 of the inner fin 100, it does not extend continuously at an end on the upstream side (left side in FIG. 14). Specifically, the projection 122 of the present practical embodiment is composed of two convex parts 124, 124 separated from each other and extending downstream (toward the right side in FIG. 14) in an inclined pattern from a center toward both sides in a flow path width direction.

Like the projection 102 of the fifth practical embodiment, the projection 122 of the present practical embodiment includes the center-low projection 116 and the center-high projection 118. In the present practical embodiment, a plurality of the center-low projections 116 and a plurality of the center-high projections 118 are arranged alternately in the flow path length direction. The projection 122 of the present practical embodiment is composed of the two convex parts 124, 124 separated from each other at a center part in the flow path width direction. Thus, the low jutting portion 112 of the center-low projection 116 and the high jutting portion 114 of the center-high projection 118 that are located on the center side in the flow path width direction are each provided at the two convex parts 124, 124.

According to the inner fin 120 structured following the present practical embodiment, it is also possible to achieve effect comparable to that of the inner fin 100 of the fifth practical embodiment. Moreover, as the projection 122 is provided only at the inclined plate 74 and is absent at the apex 76, forming the projection 122 by press working is expected to achieve simplicity of the molding.

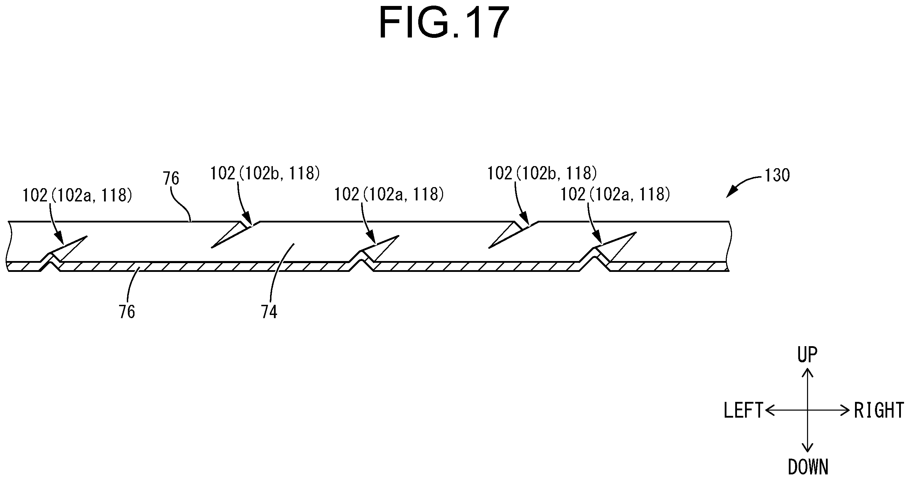

FIG. 17 depicts a part of an inner fin 130 forming a cooling heat exchanger according to a seventh practical embodiment of the present disclosure. The inner fin 130 includes a plurality of the projections 102 arranged along a flow path length direction. The projections 102 change in jutting height and spacing therebetween.

More specifically, the plurality of projections 102 have jutting height dimensions that increase toward a downstream side (right side in FIG. 17), and are arranged such that a spacing between the projections 102, 102 next to each other in the flow path length direction decreases toward the downstream side. While a change rate of the jutting height dimension of the projection 102 and a change rate of a spacing between the projections 102, 102 may vary, these change rates are constant in the present practical embodiment. The projection 102 changes in jutting height dimension in a flow path width direction. In terms of comparison between the low jutting portions 112 and/or between the high jutting portions 114, the jutting heights increase toward the downstream side.

As described above, the jutting height dimensions of the projections 102 are set to increase toward the downstream side. By so doing, on the downstream side where a large temperature difference is likely to occur between the heat medium in an upper part and the heat medium in a lower part through heat exchange, the stirring action using the projection 102 works more efficiently. Thus, retention of cooling performance can be extended to a more downstream side. Furthermore, setting spacings between the projections 102, 102 to decrease toward the downstream side also makes it possible to fulfill the stirring action using the projection 102 more efficiently on the downstream side. Thus, retention of cooling performance can be extended to a more downstream side.

While the practical embodiments of the present disclosure have been described above in detail, the present disclosure is not limited by the specific statements of the practical embodiments. For example, the specific shape of the inner fin is not limited to the shapes described in the first to fourth practical embodiments. As long as the shape of the inner fin realizes the double-sided cooling configuration by separating the cooling flow path 28 into two in the direction in which the pair of cooling walls 30, 30 face each other, it is not particularly limited. It is desirable for the inner fin to separate the cooling flow path 28 further, preferably in the flow path width direction. However, the separation in the flow path width direction is not essential but the inner fin may be configured to define only two flow path regions on the side of the cooling wall 30 of the first member 14 and on the side of the cooling wall 30 of the second member 16.

The outer wall member is not always limited to a configuration where the first member 14 and the second member 16 are superposed on each other. According to an applicable configuration, for example, a pair of lid bodies, which are respectively provided with one and the other of a supply hole and a discharge hole, are mounted on the respective ends of an outer wall body of a cylindrical shape integrally including a pair of cooling walls. In this configuration, the inner fin can be housed and arranged in an internal region of the outer wall member by inserting the inner fin into a radial inside of the outer wall body in an axis direction of the outer wall body before the lid bodies are mounted on the outer wall body, for example. The cylindrical outer wall body can be manufactured easily through injection molding of a metal material or pultrusion molding, for example.

The inner fin may not have to include the elastically-deformable part and may entirely be configured as a rigid body. In this case, as the inner fin is expected to further function as a reinforcing member, stiffness against deformation of the cooling heat exchanger is improved to encourage improvement in load bearing, etc.

The shape of the projection is not always limited to a V-shape but may be a hemispherical shape, a columnar shape, or a stepped shape, for example. The projection can also be composed of a jutting piece extending in a direction substantially orthogonal to the flow direction of the heat medium. The V-shape projection is not always limited only to a V-shape in a strict sense. As long as the projection has a V-shape as a whole on the plane of the inner fin, curvature, partial interruption, a difference in inclination angle between widthwise both portions with respect to the flow path direction, etc. are all allowable. The projection can also be a V-shape inverted from that of each of the above practical embodiments and getting narrower toward the downstream side, for example.

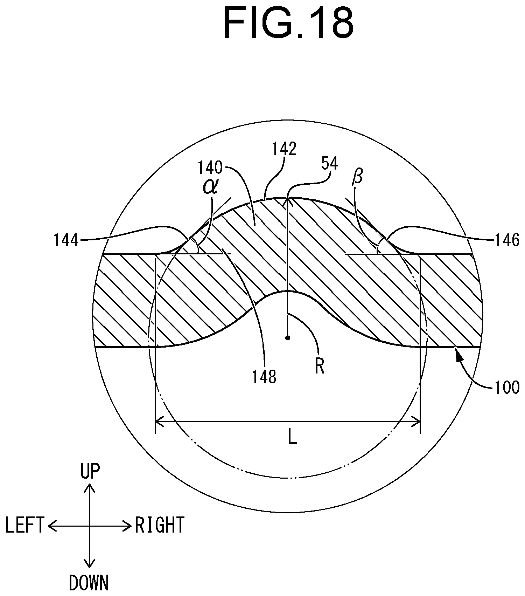

FIG. 11 depicts the projection 102 with the upstream inclined part 108 having an inclination angle within a range from 20° to 70°. Meanwhile, it is also possible to employ a projection 140 depicted in FIG. 18, for example. Specifically, the projection 140 in FIG. 18 includes a projection apex 142 having a large radius of curvature, includes an upstream inclined part 144 as an upstream-side side surface and a downstream inclined part 146 as a downstream-side side surface both configured as curved surfaces, and is provided in such a way as to smoothly connect the projection apex 142 and the inclined plate 74 to each other without a corner in a cross section in a flow path length direction. Thus, the outer shape in cross section of the projection 140 in the flow path length direction is entirely formed as a continuous curved shape. Regarding the projection 140 in FIG. 18, with respect to a length dimension L of a projection base 148, the projection apex 142 formed into an arc pattern in the cross section in the flow path length direction has a radius of curvature R that is preferably equal to or greater than 0.7 times, more preferably, an equal dimension to or greater than the length dimension L. In the cross section in the flow path length direction depicted in FIG. 18, with respect to the bottom surface of the flow path part 56, an inclination angle α of the upstream inclined part 144 of the present practical embodiment is equal to or less than 25°, and an inclination angle β of the downstream inclined part 146 of the present practical embodiment is equal to or less than 25°. Specifically, compared to the projection 102 depicted in FIG. 11, the projection 140 of the present practical embodiment has a flat shape in the cross section in the flow path length direction where a ratio of a jutting height dimension to the length dimension L of the projection base 148 is small and a change rate of a flow path cross-sectional area resulting from the projection 140 is small. The described projection 140 reduces pressure loss occurring by the flow of the heat medium in climbing over the projection 140, making it possible to circulate the heat medium using an inexpensive pump having comparatively low performance.

The projection is not always required to be provided continuously over the entire flow path width direction of the flow path part. However, the width dimension of the projection in the flow path width direction is desirably equal to or greater than 50%, more preferably, equal to or greater than 70% of the flow path width dimension of the flow path part. By so doing, a flow bypassing the projection is restricted to easily generate a flow of climbing over the projection, so that the action of disturbing the flow of the heat medium using the projection works efficiently. If the flow path width dimension of the flow path part changes in a flow path depth direction in a case where a zigzag inner fin is employed, for example, the width dimension of the projection is desirably equal to or greater than 50%, more preferably, equal to or greater than 70% of a maximum width dimension of the flow path part (a width dimension between apexes in the case of the zigzag inner fin). If the flow path width dimension of the flow path part changes in the flow path length direction, the width dimension of the projection is desirably set within the above range with respect to a flow path width dimension at a position in the presence of the projection.

The first and second members 14 and 16 may be made of synthetic resin. In this case, in order to ensure high heat conductivity, the first and second members 14 and 16 are formed using heat-conductive synthetic resin prepared by mixing a heat-conductive filler such as aluminum oxide (alumina), silica, or silicon carbide with a synthetic resin material such as polyphenylene sulfide (PPS), polyamide, polypropylene, or polybutylene terephthalate (PBT), for example.

With the battery packs 62 mounted on the cooling heat exchanger 10 as depicted in FIG. 6, the lower-side cooling surface 32 of another cooling heat exchanger 10 can be superposed on the upper surfaces of the battery packs 62 superposed on the upper-side cooling surface 32, thereby allowing the battery packs 62 to be cooled from both upper and lower sides. Likewise, the upper-side cooling surface 32 of another cooling heat exchanger 10 can also be superposed on the lower surfaces of the battery packs 62 superposed on the cooling surface 32 on the lower side. Specifically, by superposing the cooling heat exchangers 10 and the battery packs 62 alternately in the up-down direction into a stack, it becomes possible to cool a large number of the battery packs 62 from both upper and lower sides.

In arranging a plurality of the cooling heat exchangers 10 into a stack, a supply hole and a discharge hole may be respectively formed at the left and right ends of the second member 16, and the supply hole 20 and the discharge hole 22 at the first member 14 of one of the cooling heat exchangers 10 arranged next to each other in the up-down direction may be respectively connected to the supply hole and the discharge hole at the second member 16 of the other cooling heat exchanger 10 so as to communicate with each other, for example. By so doing, it becomes possible to connect the respective cooling flow paths 28 of the plurality of cooling heat exchangers 10 arranged in a stack to one external flow path, so that the heat medium can be supplied to and discharged from these cooling flow paths 28 collectively.

The cooling target is not always limited to a battery for a motorized vehicle but may be a stationary-type battery for industrial purposes, for example. In the example shown in the above-described first practical embodiment, a plurality of the battery packs 62 are mounted on the cooling surface 32 of one cooling heat exchanger 10. Meanwhile, one battery pack 62 may be mounted on the cooling surface 32 of one cooling heat exchanger 10, for example. As another example, one battery pack 62 may be arranged over a plurality of the cooling heat exchangers 10.

### Reference Signs List

- 10: cooling heat exchanger (first practical embodiment)
- 12: outer wall member
- 14: first member
- 16: second member
- 18: recessed part
- 20: supply hole
- 22: discharge hole
- 24: supply port
- 26: discharge port
- 28: cooling flow path
- 30: cooling wall
- 32: cooling surface
- 34: inner fin
- 35: edge wall
- 36: edge wall coupler
- 37: edge wall body
- 38: middle separator
- 40: projection forming part
- 42: partition wall
- 44: partition wall body
- 46: partition wall coupler
- 48: projection
- 48a: first projection
- 48b: second projection
- 50: upstream-side inclined surface
- 52: downstream-side inclined surface
- 54: ridge line
- 56: flow path part
- 58: parallel flow path portion
- 60a: first narrow flow path
- 60b: second narrow flow path
- 62: battery pack (cooling target)
- 64: terminal part
- 70: cooling heat exchanger (second practical embodiment)
- 72: inner fin
- 74: inclined plate
- 76: fold apex
- 78: projection
- 78a: first projection
- 78b: second projection
- 80: cooling heat exchanger (third practical embodiment)
- 82: inner fin
- 84: projection
- 84a: first projection
- 84b: second projection
- 90: inner fin (fourth practical embodiment)
- 100: inner fin (fifth practical embodiment)
- 102: projection
- 102a: first projection
- 102b: second projection
- 104: projection apex
- 106: projection base
- 108: upstream inclined part
- 110: downstream inclined part
- 112: low jutting portion
- 114: high jutting portion
- 116: center-low projection
- 118: center-high projection
- 120: inner fin (sixth practical embodiment)
- 122: projection
- 122a: first projection
- 122b: second projection
- 124: convex part
- 130: inner fin (seventh practical embodiment)
- 140: projection (another practical embodiment)
- 142: projection apex
- 144: upstream inclined part
- 146: downstream inclined part
- 148: projection base
- R: radius of curvature of the projection apex
- L: length dimension of the projection base
- α: inclination angle of the upstream inclined part
- β: inclination angle of the downstream inclined part

## Claims

1. A cooling heat exchanger including a cooling flow path for causing a cooling heat medium to flow therein, and a cooling surface provided on a surface of the cooling heat exchanger while being configured to be superposed on a cooling target for cooling the cooling target, the cooling heat exchanger comprising:
a hollow outer wall member in which the cooling flow path is provided, the hollow outer wall member including a pair of cooling walls separately provided at portions of the hollow outer wall member facing each other and each including the cooling surface formed on a surface of the cooling wall; and
an inner fin having a plate shape and arranged in an internal region of the hollow outer wall member, the inner fin separating the internal region into two in a direction in which the pair of cooling walls face each other while integrally including a first projection and a second projection jutting out from respective surfaces of the inner fin.

2. The cooling heat exchanger according to claim 1, wherein
the cooling flow path includes a parallel flow path portion composed of a plurality of flow path parts separated in a flow path width direction by the inner fin while extending in parallel and next to each other, and
the heat medium flows in a same direction in the plurality of flow path parts forming the parallel flow path portion.

3. The cooling heat exchanger according to claim 1 or 2, wherein
the hollow outer wall member has a structure in which a first member forming one of the pair of cooling walls and a second member forming an other of the pair of cooling walls are superposed on each other in the direction in which the pair of cooling walls face each other, and
the inner fin is arranged between the first member and the second member facing each other.

4. The cooling heat exchanger according to any one of claims 1 to 3, wherein
the inner fin has a cross section folded back in a zigzag pattern or a wave pattern in the direction in which the pair of cooling walls face each other, and
the first projection and the second projection are formed between fold apexes of the inner fin next to each other.

5. The cooling heat exchanger according to any one of claims 1 to 3, wherein
the inner fin includes a middle separator arranged apart from both the pair of cooling walls of the hollow outer wall member and separating a region between facing surfaces of the pair of cooling walls into two in the direction in which the pair of cooling walls face each other,
the first projection and the second projection are formed at the middle separator,
the inner fin includes a partition wall protruding from the middle separator to both sides toward the pair of cooling walls, and
the internal region of the hollow outer wall member is separated by the partition wall into a plurality of flow path parts in a flow path width direction of the cooling flow path.

6. The cooling heat exchanger according to any one of claims 1 to 5, wherein each of the first projection and the second projection has a V-shape on the corresponding surface of the inner fin and becomes narrower toward an upstream side of the cooling flow path.

7. The cooling heat exchanger according to any one of claims 1 to 6, wherein the inner fin is arranged partially in a flow path length direction of the cooling flow path.

8. The cooling heat exchanger according to any one of claims 1 to 7, wherein regions where action of disturbing a flow of the heat medium works differently from each other by using at least one of a plurality of the first projections and a plurality of the second projections are defined in the cooling flow path.

9. The cooling heat exchanger according to claim 8, wherein the regions where the action of disturbing the flow of the heat medium works differently from each other are defined at different positions in a flow direction of the heat medium in the cooling flow path.

10. The cooling heat exchanger according to claim 9, wherein the regions where the action of disturbing the flow of the heat medium works differently from each other and defined at the different positions in the flow direction of the heat medium in the cooling flow path are set such that the action of disturbing the flow of the heat medium works more intensely in the region located on a more downstream side.

11. The cooling heat exchanger according to any one of claims 8 to 10, wherein
the cooling flow path includes a parallel flow path portion composed of a plurality of flow path parts separated by the inner fin while extending in parallel and next to each other,
the heat medium flows in a same direction in the plurality of flow path parts forming the parallel flow path portion, and
at least one pair of the flow path parts next to each other in the parallel flow path portion include the respective regions where the action of disturbing the flow of the heat medium works differently from each other.

12. The cooling heat exchanger according to any one of claims 8 to 11, wherein the regions where the action of disturbing the flow of the heat medium works differently from each other are defined on a basis of at least one of a difference in distance between the plurality of first projections and a difference in distance between the plurality of second projections in a flow direction of the heat medium.

13. The cooling heat exchanger according to any one of claims 8 to 12, wherein the regions where the action of disturbing the flow of the heat medium works differently from each other are defined on a basis of at least one of a difference in height between the plurality of first projections and a difference in height between the plurality of second projections.

14. The cooling heat exchanger according to any one of claims 1 to 13, wherein the cooling target comprises a battery.

15. The cooling heat exchanger according to any one of claims 1 to 14, wherein the inner fin includes an elastically-deformable part to be deformed elastically to allow approach by deformation between the pair of cooling walls.

16. The cooling heat exchanger according to any one of claims 1 to 15, wherein each of the first projection and the second projection extends over an entire flow path width of the cooling flow path and is continuous with side walls of the cooling flow path at respective ends.

17. The cooling heat exchanger according to any one of claims 1 to 16, wherein
a jutting height of at least one of the first projection and the second projection changes in a flow path width direction of the cooling flow path,
the at least one of the first projection and the second projection includes a low jutting portion having a small jutting height and a high jutting portion having a large jutting height,
one of the low jutting portion and the high jutting portion is located in a center part in the flow path width direction, and
an other of the low jutting portion and the high jutting portion is located on each end in the flow path width direction.

18. The cooling heat exchanger according to claim 17, wherein
at least one of a plurality of the first projections and a plurality of the second projections arranged along a flow path length direction of the cooling flow path is composed of a center-low projection and a center-high projection arranged alternately in the flow path length direction of the cooling flow path, the center-low projection including the low jutting portion defined in the center part and the high jutting portion defined at each end in the flow path width direction of the cooling flow path, while the center-high projection including the high jutting portion defined in the center part and the low jutting portion defined at each end in the flow path width direction of the cooling flow path.

19. The cooling heat exchanger according to any one of claims 1 to 18, wherein at least one of the first projection and the second projection has a cross-sectional shape tapered toward a jutting tip in a cross section in a flow path length direction of the cooling flow path, and includes an arc-like projection apex, an upstream inclined part, and a downstream inclined part provided smoothly and continuously with each other without a corner, the upstream inclined part extending from the arc-like projection apex toward a projection base on a side of a bottom surface of the cooling flow path in an inclined pattern toward an upstream side of the cooling flow path, the downstream inclined part extending from the arc-like projection apex toward the projection base in an inclined pattern toward a downstream side.

20. The cooling heat exchanger according to claim 19, wherein
in the cross section in the flow path length direction of the cooling flow path, the arc-like projection apex has a radius of curvature within a range from 0.05 to 1.5 times a length dimension of the projection base, and
in the cross section in the flow path length direction of the cooling flow path, an inclination angle of the upstream inclined part with respect to the bottom surface of the cooling flow path is within a range from 20° to 70°.

21. The cooling heat exchanger according to claim 19, wherein in the cross section in the flow path length direction of the cooling flow path, an inclination angle of the upstream inclined part with respect to the bottom surface of the cooling flow path is equal to or less than 25°.

22. The cooling heat exchanger according to any one of claims 1 to 21, wherein at least one of the first projections and the second projections arranged along a flow path length direction in the cooling flow path have jutting heights that increase toward a downstream side.

23. The cooling heat exchanger according to any one of claims 1 to 22, wherein at least one of the first projections and the second projections arranged along a flow path length direction in the cooling flow path have spacings that decrease toward a downstream side in the flow path length direction of the cooling flow path.

24. The cooling heat exchanger according to any one of claims 1 to 23, at least one of the first projections and the second projections projections arranged along a flow path length direction in the cooling flow path have jutting heights that increase toward a downstream side while having spacings that decrease toward the downstream side in the flow path length direction of the cooling flow path.
